(19) Europäisches Patentamt / European Patent Office / Office européen des brevets

(11) EP 2 634 591 B1

(12) **FASCICULE DE BREVET EUROPEEN**

(45) Date de publication et mention de la délivrance du brevet:
**19.07.2017 Bulletin 2017/29**

(51) Int Cl.:
*G01R 31/36* (2006.01)  *H01M 10/48* (2006.01)
*H01M 4/58* (2010.01)  *H01M 10/052* (2010.01)

(21) Numéro de dépôt: **13156838.8**

(22) Date de dépôt: **26.02.2013**

(54) **Méthode et système d'estimation de l'état de charge d'un élément électrochimique au lithium comprenant une électrode positive de type phosphate lithié**

Methode und System zum Abschätzen des Ladungszustands eines elektrochemischen Elements mit Lithium, das eine positive Elektrode vom Typ Lithium-Phosphat umfasst

Method and system for estimating the charge level of a lithium electrochemical element including a lithium phosphate positive electrode

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.03.2012 FR 1251925**

(43) Date de publication de la demande:
**04.09.2013 Bulletin 2013/36**

(73) Titulaire: **SAFT**
**93170 Bagnolet (FR)**

(72) Inventeurs:
• **Benjamin, Sébastien**
**33850 Leognan (FR)**
• **Desprez, Philippe**
**33200 Bordeaux (FR)**
• **Zenati, Ali**
**33800 Bordeaux (FR)**
• **Barrailh, Gérard**
**33170 Gradignan (FR)**

(74) Mandataire: **Hirsch & Associés**
**137, rue de l'Université**
**75007 Paris (FR)**

(56) Documents cités:
WO-A1-2006/058970  WO-A1-2010/140044
FR-A1- 2 942 882  US-A1- 2007 170 893
US-A1- 2010 036 627

**Description**

DOMAINE TECHNIQUE

La présente invention concerne le domaine technique des méthodes d'estimation de l'état de charge d'un élément électrochimique pour lequel une mesure de la tension ne permet pas en permanence d'estimer avec précision son état de charge. Un tel élément présente généralement un profil de charge comprenant au moins une zone dans laquelle la tension ne varie pas de manière continûment proportionnelle avec l'état de charge. L'invention concerne également les systèmes électroniques permettant de mettre en oeuvre les méthodes d'estimation de l'état de charge de l'élément.

ETAT DE LA TECHNIQUE

Un générateur électrochimique ou accumulateur ou élément (encore désigné par le terme « élément »), est un dispositif de production d'électricité dans lequel de l'énergie chimique est convertie en énergie électrique. L'énergie chimique est constituée par des composés électrochimiquement actifs déposés sur au moins une face d'électrodes disposées dans l'élément. L'énergie électrique est produite par des réactions électrochimiques au cours d'une décharge de l'élément. Les électrodes, disposées dans un conteneur, sont connectées électriquement à des bornes de sortie de courant qui assurent une continuité électrique entre les électrodes et un consommateur électrique auquel l'élément est associé.

Typiquement une batterie comprend une pluralité d'éléments susceptibles d'être regroupés au sein d'une même enceinte. Une batterie peut être divisée en modules, chaque module étant composé d'une pluralité d'éléments reliés entre eux en série et/ou en parallèle. La batterie est destinée à fournir de l'énergie électrique à une application extérieure. Un circuit de charge est généralement prévu auquel la batterie peut être branchée pour recharger les éléments. Un système de gestion comprenant des capteurs de mesures et un circuit électronique de contrôle, plus ou moins évolué selon les applications, peut être associé à la batterie.

Il est connu des documents EP-A-2 144 075, EP-A-2 239 826 et EP-A-2 309 615 d'utiliser comme matériau d'électrode positive d'un élément des phosphates lithiés d'au moins un métal de transition, notamment les composés de type $LiMPO_4$ où M est choisi dans le groupe comprenant Fe, Co, Ni, Mn et un mélange de ceux-ci. Ces phosphates lithiés présentent une meilleure stabilité thermique que les oxydes lithiés de métaux de transition de type $LiM^1O_2$ classiquement utilisés dans les éléments au lithium, où $M^1$ représente au moins un élément de transition choisi généralement parmi Co, Ni et Fe. L'utilisation de phosphates lithiés permet donc de réduire le risque de réactions violentes dans le cas où l'accumulateur est placé dans des conditions de surcharge.

Il est aussi connu d'utiliser comme matière active un mélange comprenant $LiMPO_4$ et un composé de type $LiM^1O_2$ où $M^1$ représente au moins un élément de transition choisi généralement parmi Co, Ni, Fe, Mn et Al. En particulier, le document EP-A-2 269 954 divulgue une matière électrochimiquement active qui est un mélange comprenant :

a) moins de 10% en poids d'un oxyde lithié de métaux de transition contenant au moins nickel, cobalt et aluminium et
b) au moins 90% en poids d'un phosphate lithié d'au moins un métal de transition, dont la surface est recouverte au moins partiellement d'une couche de carbone. Ce type de matière active présente un bon compromis entre capacité élevée et stabilité thermique.

Dans des éléments dont l'électrode positive comprend une matière électrochimiquement active de type phosphate lithié ou du type de celle décrite dans le document EP-A-2 269 954, la tension de l'élément varie très faiblement en fonction de son état de charge pour un état de charge compris entre environ 30 et environ 90%. On rappelle que l'état de charge (SOC « state of charge » en anglais) est déterminé comme la quantité d'énergie disponible dans la batterie rapportée à l'énergie d'une batterie totalement chargée. Il s'exprime en pourcentage et reflète la part d'énergie restante disponible pour l'utilisateur. Dans ce type d'élément, la variation de la tension à vide en fonction de l'état de charge présente une zone pour un état de charge compris entre environ 30 et environ 90% dans laquelle la tension à vide augmente au moins 10 fois moins rapidement en fonction de l'état de charge en moyenne que pour un état de charge compris entre 90% et 100%.

On entend par tension à vide la tension mesurée aux bornes de l'élément lorsque celui-ci ne débite aucun courant (« Open circuit voltage » en anglais et également dénommé « tension en circuit ouvert » ; selon la définition 482-03-32 de la norme CEI 60050-482 :2004, Vocabulaire électrotechnique international partie 482 : piles et accumulateurs électriques).

On entend par variation de la tension en fonction de l'état de charge, soit la dérivée de la tension par rapport à l'état de charge, soit le rapport $\Delta V/\Delta SOC=(V2-V1)/(SOC2-SOC1)$ où

- V1 et V2 représentent les valeurs de tensions de deux points situés sur la courbe de la tension en fonction de l'état de charge ; et
- SOC2 et SOC1 représentent les états de charge correspondant aux valeurs de tension V1 et V2.

Par exemple, un élément dont l'électrode positive comprend une matière électrochimiquement active de type lithium fer phosphate LiFePO$_4$ chargée à un courant de C/5 Ampère a une tension qui augmente d'environ 0,5 millivolt par minute pour un état de charge compris entre 30 et 90% et augmente d'environ de 20 millivolts par minute pour un état de charge compris entre 90% et 100%, C étant la capacité nominale de l'élément. En raison de cette très faible variation de tension, il est difficile d'estimer avec précision l'état de charge de l'élément en fonction de sa tension lorsque l'état de charge est compris entre environ 30 et 90%.

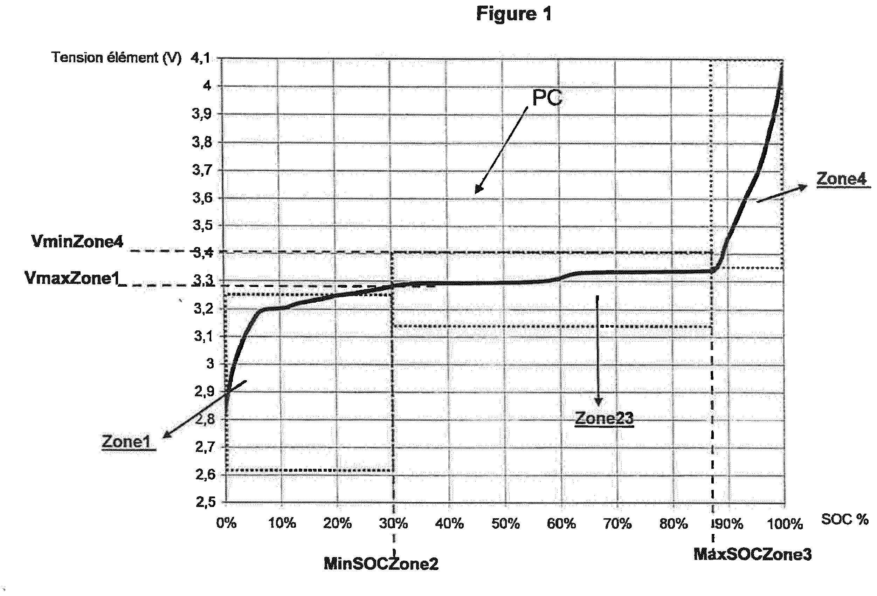

La Figure 1 représente schématiquement le profil de charge (PC) d'un élément dont l'électrode positive comprend une matière électrochimiquement active de type de celle décrite dans le document EP-A-2 269 954. Les trois zones principales sont représentées :

**Zone 1:** elle correspond à une tension inférieure ou égale à VmaxZone1. A la valeur VmaxZone1 correspond un état de charge égal à MinSOCZone2. VmaxZone1 se situe en général entre 3 et 3,30V et vaut typiquement 3,30V. MinSOCZone2 se situe généralement dans la gamme allant de 15 à 30%, typiquement 30%. Dans la zone 1, la tension varie quasiment proportionnellement avec l'état de charge ; c'est-à-dire qu'à une tension donnée de l'élément correspond un état de charge donné. La zone 1 se subdivise encore en une première zone d'état de charge comprise entre 0 et moins de 10%, dans laquelle la tension de l'élément varie de plus 300 mV et une seconde zone d'état de charge comprise entre typiquement 10% et typiquement 30%, dans laquelle la tension varie moins vite en fonction de l'état de charge, par exemple d'environ 100 mV pour un accroissement d'état de charge de 20%.

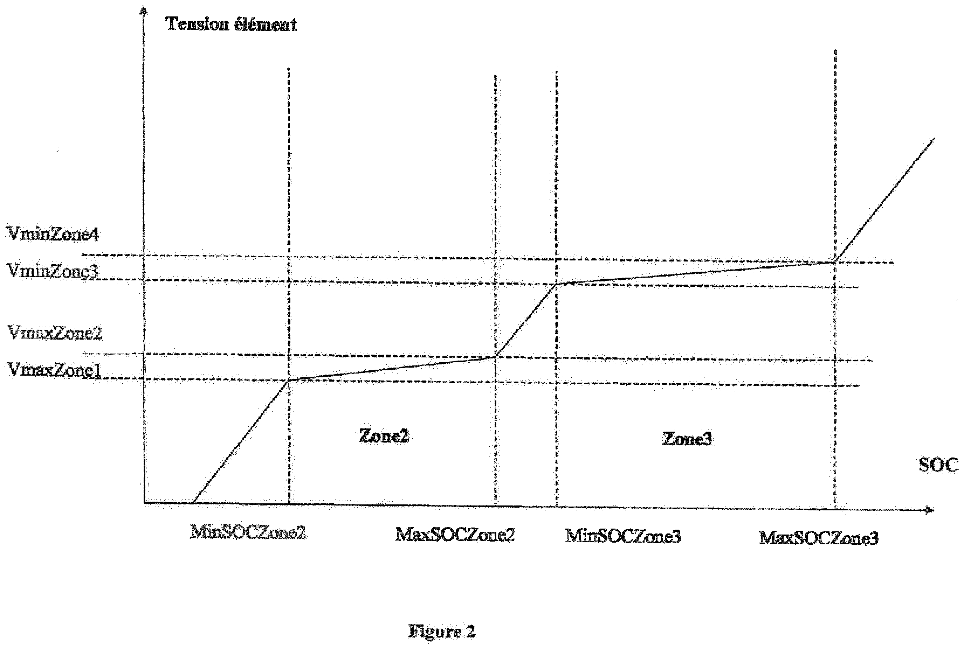

**Zone 23:** elle correspond à une tension supérieure à VmaxZone1 et inférieure à VminZone4. VminZone4 se situe en général entre 3,35 et 3,45V, et vaut typiquement 3,40V. A la valeur VminZone4 correspond un état de charge égal à MaxSOCZone3. MaxSOCZone3 se situe généralement dans la gamme allant de 80 à 95%, typiquement 90%. La zone 23 correspond typiquement à la zone de tensions comprises entre 3,30 V et 3,40 V correspondant à un état de charge compris typiquement entre 30% et typiquement 90 %. On peut noter une variation de tension de l'élément quasi nulle pour un état de charge compris entre 30% et 60% et pour un état de charge compris entre 65% et 90%. Dans la zone 23, la tension de l'élément varie peu, typiquement de l'ordre de 100 mV pour un état de charge compris entre environ 30 et environ 90%. Il en résulte une forte imprécision sur la mesure de l'état de charge dans la zone 23 puisqu'une valeur donnée de tension peut correspondre à un état de charge compris dans une large plage allant de 30 à 90%. La zone 23 se subdivise en deux sous-zones comme le montre la figure 2 qui est un agrandissement de la figure 1: une première sous-zone : la zone 2 allant de MinSOCZone2 à MaxSOCZone2, soit de 30 à 60% et une seconde sous-zone, la zone 3 allant de MinSOCZone3 à MaxSOCZone3, soit de 65 à 90%. Les zones 2 et 3 se rejoignent vers un état de charge compris entre 60 et 65%.

**Zone 4:** elle correspond à une tension supérieure ou égale à VminZone4. A la valeur VminZone4 correspond un état de charge égal à MaxSOCZone3. VminZone4 correspond à un état de charge d'environ 90%. Dans cette zone, la tension varie proportionnellement avec l'état de charge. Elle varie d'environ au moins 300 mV. A une tension donnée de l'élément correspond un état de charge donné.

Ce profil de charge est commun aux composés de type LiMPO$_4$ où M est choisi dans le groupe comprenant Fe, Co, Ni, Mn et un mélange de ceux-ci.

Dans la zone 1, la variation de la tension de l'élément en fonction de l'état de charge pour un état de charge inférieur à MinSOCzone2 correspondant à une tension Vmaxzone1 est en moyenne au moins 2 fois plus rapide que la variation de la tension pour un état de charge compris entre MinSOCZone2 et MaxSOCZone3.

Le document US 2010/0036627 décrit une méthode pour déterminer l'état de charge d'une batterie qui a été chargée ou déchargée et qui n'a pas atteint son état d'équilibre, ladite méthode comprenant les étapes suivantes:

- la détermination de la force électromotrice de la batterie par l'extrapolation de la tension de batterie échantillonnée pendant la relaxation après la charge ou la décharge, dans laquelle l'extrapolation est basée sur un modèle d'extrapolation utilisant uniquement des variables échantillonnées durant le processus de relaxation, et
- la déduction de l'état de charge de la batterie à partir de la force électromotrice de la batterie en utilisant une relation prédéterminée entre la force électromotrice et l'état de charge de la batterie.

Le document WO 2006/058970 décrit une méthode d'évaluation de l'état de charge, qui donne des résultats fiables en temps réel, et ce sur une large plage de valeurs d'état de charge. Cette méthode se caractérise en ce que l'on calcule, pendant les phases de décharge de la batterie, l'écart entre la valeur d'état de charge coulométrique, et une valeur prédéterminée d'un état de charge théorique, qui est calculée en fonction de la tension aux bornes de la batterie, de l'intensité du courant de décharge, de la température de la batterie, et de sa capacité nominale. Cet écart est alors utilisé pour modifier le calcul de l'état de charge coulométrique qui est obtenu par intégration temporelle de l'intensité du courant de charge et de décharge de la batterie. En particulier, si cet écart dépasse un premier seuil prédéterminé, on peut modifier la valeur courante de l'état de charge coulométrique par la valeur correspondant à l'état de charge théorique. Autrement dit, la méthode décrite consiste à recaler le modèle coulométrique par un modèle théorique, dont la valeur ne dépend, pour un type de batterie donné, que de trois paramètres mesurés que sont la tension aux bornes de la batterie, l'intensité du courant de décharge et la température de la batterie. Ce modèle théorique est pertinent dans les situations de décharge de la batterie, c'est-à-dire en pratique sur un véhicule, lorsque la puissance consommée par les différents appareils alimentés par la batterie est supérieure à la puissance que peut fournir le dispositif de charge généralement constitué par un alternateur.

Le document FR 2 942 882 décrit un procédé d'estimation de la force électromotrice à l'équilibre d'une batterie, basé sur des données relatives à l'évolution dans le temps de la tension à vide aux bornes d'une telle batterie en cours de relaxation. Ces données peuvent être obtenues par des essais préliminaires sur une telle batterie, dans différentes conditions de température. Ce document décrit également un procédé d'estimation de l'état de charge d'une batterie, en fonction de la force électromotrice à l'équilibre. Cette estimation de l'état de charge est basée sur des données relatives à la correspondance d'un état de charge défini et d'une force électromotrice à l'équilibre définie, pour une température donnée. Ces données peuvent être obtenues par des essais préliminaires sur une telle batterie, dans différentes conditions de température.

Le document US 2007/0170893 décrit un procédé de mesure de la capacité restante d'une batterie, ledit comprenant les étapes de:

a) mesure d'une tension en circuit ouvert,
b) obtention d'une capacité de la batterie sur la base de la tension en circuit ouvert,
c) stockage de la capacité de la batterie dans un compteur d'accumulation,
d) ajustement du compteur d'accumulation en fonction d'un procédé de décharge et de charge de la batterie ; et
e) obtention de la capacité restante de la batterie basée sur le compteur d'accumulation.

Le document WO 2010/140044 décrit un dispositif de commande pour un véhicule. Le véhicule comprend une batterie et un moteur recevant la puissance électrique de la batterie. Les variations de la tension en circuit ouvert en fonction de l'état de charge de la batterie présentent une première région dans laquelle la variation de la tension en circuit ouvert en fonction de la variation de l'état de charge dépasse une valeur seuil, et une seconde région dans laquelle la variation de la tension en circuit ouvert en fonction de la variation de l'état de la charge ne dépasse pas la valeur seuil. Dans le cas d'une valeur estimée de l'état de charge de la batterie se situant à l'intérieur de la première région, le dispositif de commande met à jour la valeur estimée de l'état de charge de la batterie en estimant l'état de la charge selon une première méthode d'estimation qui utilise la tension de la batterie, et dans le cas d'une valeur estimée de l'état de charge de la batterie se situant à l'intérieur de la seconde région, le dispositif de commande met à jour la valeur estimée de l'état de charge de la batterie en estimant l'état de la charge en fonction d'un second méthode d'estimation qui utilise le courant d'entrée et de sortie de la batterie. Dans le cas d'une période de temps pendant laquelle la valeur estimée de l'état de charge de la batterie se situe à l'intérieur de la seconde zone, et est supérieure à une durée prescrite, le dispositif de commande modifié temporairement l'état de charge de la batterie de sorte que l'état de charge de la batterie se situe dans la première région et il estime l'état de la charge par la première méthode d'estimation.

Il n'existe actuellement pas de méthode susceptible d'être adaptée de manière satisfaisante à l'estimation de l'état de charge d'un élément électrochimique dont l'électrode positive comprend une matière électrochimiquement active de type phosphate lithié / ou du type de celle décrite dans EP-A-2 269 954. Il existe donc un besoin pour un système et pour une méthode d'estimation de l'état de charge pour ce type d'élément.

On recherche donc une méthode permettant de déterminer avec précision l'état de charge d'un élément présentant un profil de charge du type décrit ci-avant.

RESUME DE L'INVENTION

A cet effet, la présente invention propose une méthode d'estimation de l'état de charge (SOC) d'un élément (E) comprenant une électrode comprenant une matière électrochimiquement active présentant un profil de charge (PC) dans lequel, pour un état de charge compris entre environ 30% et environ 90%, la tension augmente au moins 10 fois moins rapidement en fonction du temps en moyenne que pour un état de charge supérieur à 90%. Cette méthode s'applique à la gestion de l'état de charge d'un élément comprenant une électrode positive de type phosphate lithié ou du type de celle décrite dans le document EP-A-2 269 954. Cette méthode consiste en une gestion de l'état de charge optimisée selon les zones du profil de charge (PC) définies par des limites de tension et d'état de charge

L'invention vise donc une méthode d'estimation de l'état de charge (SOC) d'un élément (E) comprenant une électrode comprenant une matière électrochimiquement active présentant un profil de charge (PC), profil de charge dans lequel la variation de la tension en fonction de l'état de charge entre un état de charge supérieur à une valeur d'état de charge MinSOCzone2 correspondant à une tension Vmaxzone1 prédéterminée et un état de charge inférieur à une valeur d'état de charge MaxSOCzone3 correspondant à une tension VminZone4 prédéterminée est en moyenne au moins 10 fois moins rapide que la variation de la tension pour un état de charge supérieur à MaxSOCzone3, et le profil de charge comprend en outre une zone dans laquelle la variation de la tension dudit élément E en fonction de l'état de charge pour un état de charge inférieur à MinSOCzone2 correspondant à une tension VmaxZone1 est en moyenne au moins 2 fois plus rapide que la variation de la tension pour un état de charge compris entre MinSOCzone2 et MaxSOCZone3, et

le profil de charge présente pour un état de charge compris entre MinSOCZone2 et MaxSOCZone3 :

- une première sous-zone allant de MinSOCZone2 à une valeur d'état de charge MaxSOCZone2 ; la valeur MaxSOCZone2 correspondant à une valeur de tension VmaxZone2 prédéterminée;
- une seconde sous-zone allant d'une valeur d'état de charge MinSOCZone3 à MaxSOCZone3 ; la valeur d'état de charge MinSOCZone3 correspondant à une valeur de tension VminZone3 prédéterminée;

ladite méthode comprenant les étapes suivantes :

a) mise à disposition de l'élément ; connexion de l'élément avec un dispositif de charge ou de décharge et mesure du courant I traversant l'élément ; mise à disposition d'une relation d'étalonnage entre l'état de charge de l'élément et sa tension ;
b) mise à disposition de l'état de charge initial $SOC(t_0)$ à un instant initial $t_0$ de l'élément (E) ;
c) mesure de la tension $V(t_n)$ de l'élément E et détermination d'un état de charge ajusté $SOC(t_n)$ de l'élément E à un instant $t_n$ supérieur à $t_0$ lorsque $V(t_n)$ est supérieure ou égale à VminZone4, dans les conditions suivantes :

i) si l'élément E est traversé par un courant $I(t_n)$ inférieur en valeur absolue à une valeur seuil de courant prédéterminée Iseuil depuis une durée supérieure à une valeur t_zone4 prédéterminée, alors on détermine une valeur $SOCV(t_n)$ à partir de la relation d'étalonnage de la tension en fonction de l'état de charge, on affecte à $SOC(t_n)$ la valeur $SOCV(t_n)$ et on attribue une valeur nulle à un paramètre correspondant à l'erreur cumulée sur l'état de charge obtenu par coulométrie ErreurcumuléeSOCC$(t_n)$;
ii) sinon on affecte à $SOC(t_n)$ une valeur $SOCC(t_n)$ déterminée par coulométrie et on détermine l'erreur de mesure cumulée ErreurcumuléeSOCC$(t_n)$ sur la mesure de l'état de charge $SOCC(t_n)$ de l'élément E entre l'instant $t_0$ et l'instant $t_n$, et

l'étape c) comprend en outre la détermination d'un état de charge ajusté $SOC(t_n)$ dudit élément à un instant $t_n$ supérieur à $t_0$, lorsque la tension $V(t_n)$ dudit élément est inférieure ou égale à VmaxZone1, dans les conditions suivantes :

i) si l'élément E est traversé par un courant $I(t_n)$ inférieur en valeur absolue à une valeur seuil de courant prédéterminée Iseuil' depuis une durée supérieure à une valeur t_zone1 prédéterminée, alors on détermine une valeur $SOCV(t_n)$ à partir de la relation d'étalonnage de la tension en fonction de l'état de charge, on affecte à $SOC(t_n)$ la valeur $SOCV(t_n)$ et on attribue une valeur nulle à un paramètre correspondant à l'erreur cumulée sur l'état de charge obtenu par coulométrie ErreurcumuléeSOCC$(t_n)$ ;
ii) sinon on affecte à $SOC(t_n)$ la valeur $SOCC(t_n)$ déterminée par coulométrie et on détermine l'erreur de mesure cumulée ErreurcumuléeSOCC$(t_n)$ sur la mesure de l'état de charge $SOCC(t_n)$ de l'élément E entre l'instant $t_0$ et l'instant $t_n$, et

l'étape c) comprend en outre l'affectation d'une valeur $SOC(t_n)$ audit élément E à un instant $t_n$ supérieur à $t_0$ lorsque sa tension $V(t_n)$ est supérieure à VmaxZone1 et inférieure à VminZone4, dans les conditions suivantes :

i) si l'élément E est traversé par un courant $I(t_n)$ inférieur en valeur absolue à une valeur de courant seuil prédéterminée égale à min(Iseuil, Iseuil') depuis une durée supérieure à une valeur t zone23 prédéterminée, l'affectation se fait selon les conditions suivantes :

- si $SOCC(t_n) >$ MaxSOCzone3 alors on affecte à $SOC(t_n)$ la valeur MaxSOCzone3 et on retranche à l'erreur cumulée sur l'état de charge déterminé par coulométrie la valeur ($SOCC(t_n)$ - MaxSOCzone3) ;
- si $SOCC(t_n) <$ MinSOCzone2 alors on affecte à $SOC(t_n)$ la valeur MinSOCzone2 et on retranche à l'erreur cumulée sur l'état de charge déterminé par coulométrie la valeur (MinSOCzone2 - $SOCC(t_n)$) ;
- si $V(t_n) <$ VmaxZone2 et si $SOCC(t_n) >$ MaxSOCZone2 alors on affecte à $SOC(t_n)$ la valeur

MaxSOCZone2 et on retranche à l'erreur cumulée sur l'état de charge déterminé par coulométrie la valeur (SOCC($t_n$) - MaxSOCZone2);

- si V($t_n$) > VminZone3 et si SOCC($t_n$) < MinSOCZone3 alors on affecte à SOC($t_n$) la valeur MinSOCZone3 et on retranche à l'erreur cumulée sur l'état de charge déterminé par coulométrie la valeur (MinSOCZone3 - SOCC($t_n$)) ;

ii) sinon on affecte à SOC($t_n$) un état de charge SOCC($t_n$) déterminé par coulométrie et on détermine l'erreur de mesure cumulée ErreurcumuléeSOCC($t_n$) sur la mesure de l'état de charge SOCC($t_n$) de l'élément E à l'instant $t_n$.

La méthode permet de déterminer avec précision l'état de charge de l'élément lorsque celui-ci est compris entre 90 et 100%. Elle permet donc de prévenir toute surcharge de l'élément.

L'invention permet de déterminer avec précision l'état de charge de l'élément lorsque celui-ci est compris entre 0 et 30%, de préférence entre 0 et 10%. Il permet donc d'éviter le risque de surdécharge de l'élément.

L'invention permet d'effectuer un ajustement partiel de l'état de charge lorsque la tension de l'élément se situe dans la zone 23 du profil de charge (zone dite « plate » du profil de charge).

Selon un mode de réalisation, on estime l'état de charge de l'élément E à un instant $t_{n+1}$ supérieur à $t_n$ selon les conditions suivantes :

- si la condition c)i) est remplie au temps $t_n$, alors on réinitialise l'état de charge initial SOC($t_0$) en lui affectant la valeur SOCV($t_n$) et on effectue les étapes b) et c) avec $t_0 = t_n$ et $SOCC(t_{n+1}) = \Delta SOCC(t_{n+1}\text{-}t_n) + SOC(t_n)$ ;

- si la condition c)ii) est remplie, alors $SOCC(t_{n+1}) = \Delta SOCC(t_{n+1}\text{-}t_n) + SOC(t_n)$ ; où $\Delta SOCC(t_{n+1}\text{-}t_n)$ désigne la variation d'état de charge de l'élément E déterminée par coulométrie entre les instants $t_n$ et $t_{n+1}$.

Selon un mode de réalisation, l'erreur sur l'état de charge obtenu par coulométrie $\Delta$ErreurSOC entre les instants $t_n$ et $t_{n+1}$ vaut :

$$\Delta \text{ErreurSOC}(\%) = 100 \times \frac{\left[ \text{ErreurIOffsetSOC} + \frac{\left( \text{ErreurIGain} \times \text{Abs(I)} \right)}{100} \right] \times (t_{n+1} - t_n)}{3600 \times C}$$

avec:

ErreurIOffsetSOC : erreur d'offset du dispositif de mesure du courant exprimée en Ampère ;
ErreurIGain : erreur de gain du dispositif de mesure du courant exprimée en pourcentage du courant mesuré ;
Abs(I) : valeur absolue du courant I traversant l'élément exprimée en Ampère ;
C : capacité de l'élément exprimée en Ampère heure ;
$t_{n+1}\text{-}t_n$ : temps écoulé entre deux mises à jours de l'état de charge, exprimé en secondes.

Selon un mode de réalisation, on calcule à l'instant $t_{n+1}$ l'erreur cumulée sur l'état de charge depuis l'ajustement de l'état de charge au temps précédent $t_n$ selon la relation suivante :

$$\text{ErreurcumuléeSOC}(t_{n+1}) \, (\%) = \text{ErreurcumuléeSOC}(t_n) + \Delta \text{ErreurSOC}(t_{n+1})$$

où

ErreurcumuléeSOC($t_{n+1}$) représente la mise à jour de l'erreur cumulée sur l'état de charge au temps $t_{n+1}$ résultant de l'erreur de mesure du capteur de courant ; ErreurcumuléeSOC($t_n$) représente la valeur de l'erreur cumulée à l'instant de mesure précédent $t_n$ ; et
ErreurcumuléeSOC($t_0$)=0.

Selon un mode de réalisation, la méthode comprend après l'étape c)ii), l'une des étapes suivantes :

$\alpha$) affectation à l'état de charge $SOC(t_n)$ d'une valeur prédéterminée SOCsup, de préférence comprise entre 90% et 100% si d'une part $SOC(t_n)$ est supérieur à la valeur d'état de charge SOCsup et si d'autre part la tension en charge $V(t_n)$ est inférieure à une valeur de tension seuil prédéterminée Vs1 pendant une durée prédéterminée t6 ou

$\beta$) affectation à l'état de charge $SOC(t_n)$ d'une valeur prédéterminée SOCinf, de préférence inférieure à 10% si d'une part $SOC(t_n)$ est inférieur à la valeur d'état de charge SOCinf et si d'autre part la tension en décharge $V(t_n)$ est supérieure à une valeur de tension seuil prédéterminée Vs2 pendant une durée prédéterminée t7.

Selon un mode de réalisation, la méthode comprend après l'étape c)ii) l'étape suivante:

$\gamma$) affectation à l'état de charge $SOC(t_n)$ de la valeur 0% si d'une part $SOC(t_n)$ est inférieur à une valeur d'état de charge seuil de sécurité SOCminsafe, par exemple 20%, et si d'autre part, la valeur de la tension en décharge $V(t_n)$ est inférieure à une valeur prédéterminée de tension Vminsafe pendant une durée prédéterminée t8.

Selon un mode de réalisation, la méthode comprend l'interruption de la charge ou de la décharge de l'élément lorsque l'erreur cumulée ErreurcumuléeSOCC$(t_n)$ de l'élément E dépasse une valeur seuil prédéterminée et/ou on envoie un message d'alerte à un utilisateur.

Selon un mode de réalisation, on mesure la température de l'élément E et Iseuil et Iseuil' varient de manière croissante lorsque la température de l'élément croît.

Selon un mode de réalisation, on mesure la température de l'élément E et t_zone4, t_zone1 et t_zone23 varient de manière décroissante lorsque la température de l'élément croît.

Selon un mode de réalisation, on ajuste les durées t_zone4, t_zone1 et t_zone23 en fonction de la température en réduisant lesdites durées lorsque la température augmente.

Selon un mode de réalisation, on corrige les valeurs de VminZone4 et VmaxZone1 pour tenir compte de la résistance interne r de l'élément E, laquelle correction consiste à ajouter à VminZone4 et à VmaxZone1 la quantité $r \times I(t_n)$, où $I(t_n)$ est négatif lorsque l'élément est en décharge et positif lorsque l'élément est en charge.

La méthode propose la stratégie d'ajustement de l'état de charge la plus précise en fonction de la valeur de la tension de l'élément par rapport aux valeurs de tensions prédéterminées VmaxZone1 et VminZone4 et selon que l'élément est au repos ou utilisé en charge ou en décharge. Lorsque la tension se trouve dans la zone 1 ou la zone 4, que l'élément est au repos ou est utilisé en charge ou en décharge à un courant d'intensité inférieure en valeur absolue à une valeur seuil prédéterminée et que la tension présente une valeur stable au cours du temps, l'état de charge de l'élément est ajusté en lui affectant une valeur préalablement obtenue par étalonnage de la tension de l'élément en fonction de son état de charge. Cet étalonnage est réalisé préalablement en laboratoire sur un élément pris isolément et consiste à faire correspondre pour une tension donnée aux bornes de l'élément, un état de charge donné. Cet étalonnage peut par exemple être réalisé en déterminant la tension à vide de l'élément en fonction de son état de charge.

Dans les cas où :

- l'élément est au repos mais que sa tension n'est pas stabilisée, ou
- l'élément est utilisé en charge ou en décharge à un courant d'intensité inférieure en valeur absolue à une valeur seuil prédéterminée mais que sa tension n'est pas stabilisée ou
- l'intensité du courant traversant l'élément est supérieure en valeur absolue à la valeur seuil de courant prédéterminée,

alors la méthode détermine l'état de charge de l'élément par coulométrie en tenant compte de l'incertitude de mesure sur le capteur de courant.

L'invention a également pour objet un système d'estimation de l'état de charge d'au moins un élément électrochimique (E), lequel élément présente un profil de charge (PC) dans lequel la variation de la tension en fonction de l'état de charge entre un état de charge supérieur à une valeur d'état de charge MinSOCzone2 correspondant à une tension VmaxZone1 prédéterminée et un état de charge inférieur à une valeur d'état de charge MaxSOCzone3 correspondant à une tension VminZone4 prédéterminée est en moyenne au moins 10 fois moins rapide que la variation de la tension pour un état de charge supérieur à MaxSOCzone3, et

le profil de charge comprend en outre une zone dans laquelle la variation de la tension dudit élément E en fonction de l'état de charge pour un état de charge inférieur à MinSOCzone2 correspondant à une tension VmaxZone1 est en moyenne au moins 2 fois plus rapide que la variation de la tension pour un état de charge compris entre MinSOCZone2 et MaxSOCZone3, et

le profil de charge présente pour un état de charge compris entre MinSOCZone2 et MaxSOCZone23:

- une première sous-zone allant de MinSOCZone2 à une valeur d'état de charge MaxSOCZone2 ; la valeur MaxSOCZone2 correspondant à une valeur de tension VmaxZone2 prédéterminée;
- une seconde sous-zone allant d'une valeur d'état de charge MinSOCZone3 à MaxSOCZone3 ; la valeur d'état de charge MinSOCZone3 correspondant à une valeur de tension VminZone3 prédéterminée;

ledit système comprenant :

a) un moyen de mesure du courant I traversant l'élément ;
b) un moyen de mesure de la tension V de l'élément E;
c) un système électronique de gestion G de l'élément, comprenant un calculateur configuré pour :

-   calculer l'état de charge de l'élément E par coulométrie;
-   réaliser l'estimation de l'état de charge de l'élément E selon la méthode telle que décrite ci-dessus.

Selon un mode de réalisation, le système comprend un moyen de mise en mémoire de l'état de vieillissement SOH de l'élément E.

L'invention a également pour objet un ensemble comprenant :

-   le système tel que décrit ci-dessus ;
-   au moins un élément (E) présentant un profil de charge (PC) dans lequel la variation de la tension en fonction de l'état de charge entre un état de charge supérieur à une valeur d'état de charge MinSOCzone2 correspondant à une tension VmaxZone1 prédéterminée et un état de charge inférieur à une valeur d'état de charge MaxSOCzone3 correspondant à une tension VminZone4 prédéterminée est en moyenne au moins 10 fois moins rapide que la variation de la tension pour un état de charge supérieur à MaxSOCzone3, et

le profil de charge comprend en outre une zone dans laquelle la variation de la tension dudit élément E en fonction de l'état de charge pour un état de charge inférieur à MinSOCzone2 correspondant à une tension VmaxZone1 est en moyenne au moins 2 fois plus rapide que la variation de la tension pour un état de charge compris entre MinSOCZone2 et MaxSOCZone3, et

le profil de charge présente pour un état de charge compris entre MinSOCZone2 et MaxSOCZone3:

-   une première sous-zone allant de MinSOCZone2 à une valeur d'état de charge MaxSOCZone2 ; la valeur MaxSOCZone2 correspondant à une valeur de tension VmaxZone2 prédéterminée;
-   une seconde sous-zone allant d'une valeur d'état de charge MinSOCZone3 à MaxSOCZone3 ; la valeur d'état de charge MinSOCZone3 correspondant à une valeur de tension VminZone3 prédéterminée.

Selon un mode de réalisation, l'élément comprend une électrode positive contenant:

-   soit un composé a) de formule $Li_xM_yP_zO_{4-t}$ dans laquelle M est choisi dans le groupe comprenant Fe, Co, Ni, Mn, Al et un mélange de ceux-ci, x allant de 0,9 à 1,1 et y de 0,9 à 1,1, z allant de 0,9 à 1,1 et t allant de 0 à 0,4, où M est de préférence Fe ou un mélange de Fe et Mn;
-   soit un mélange b) du composé a) avec un oxyde lithié de formule $LiM^1O_2$ dans laquelle $M^1$ désigne au moins un élément choisi parmi Co, Ni, Mn, Al et Fe, ou un mélange de ceux-ci.

Selon un mode de réalisation, le matériau électrochimiquement actif choisi est une composition comprenant :

-   au moins 50% en poids du composé a) ;
-   moins de 50% en poids d'un oxyde lithié de formule $LiM^1O_2$ dans laquelle $M^1$ désigne au moins un élément choisi parmi Co, Ni, Mn, Al et Fe, ou un mélange de ceux-ci.

Selon un mode de réalisation, la composition comprend :

-   au moins 90% en poids du composé a) dont la surface est de préférence au moins partiellement recouverte d'une couche de carbone;
-   10% ou moins en poids de l'oxyde lithié de formule $LiM^1O_2$.

L'invention a également pour objet un produit de programme d'ordinateur comprenant au moins une séquence d'instructions stockées et accessibles à un processeur, où l'exécution du processeur conduit à la mise en oeuvre des étapes de la méthode décrite ci-dessus.

L'invention a également pour objet un support d'information lisible par un ordinateur, comprenant ledit programme d'ordinateur.

DESCRIPTION DES FIGURES :

La figure 1 représente la variation à 30°C de la tension à vide en fonction de l'état de charge d'un élément dont l'électrode positive comprend une matière électrochimiquement active du type de celle décrite dans le document EP-A-2 269 954.

La figure 2 est un agrandissement schématique de la figure 1 dans la zone 23.

La figure 3 représente un schéma de principe du système de gestion de l'état de charge d'une batterie dans lequel une batterie (Bat) comprend trois modules (M1, M2, M3), comportant chacun quatre éléments électrochimiques (E11, E12, E13, E14, E21, E22, E23, E24, E31, E32, E33, E34).

La figure 4 représente un organigramme schématisant le principe d'ajustement de l'état de charge de l'élément dans les trois situations suivantes :

- la tension de l'élément se situe dans la zone 4. L'élément est « au repos », c'est-à-dire qu'il est traversé par un courant inférieur à Iseuil ;
- la tension de l'élément se situe dans la zone 1. L'élément est « au repos », c'est-à-dire qu'il est traversé par un courant inférieur à Iseuil' ;
- la tension de l'élément se situe dans la zone 23. L'élément est « au repos », c'est-à-dire qu'il est traversé par un courant inférieur à min(Iseuil, Iseuil') ;

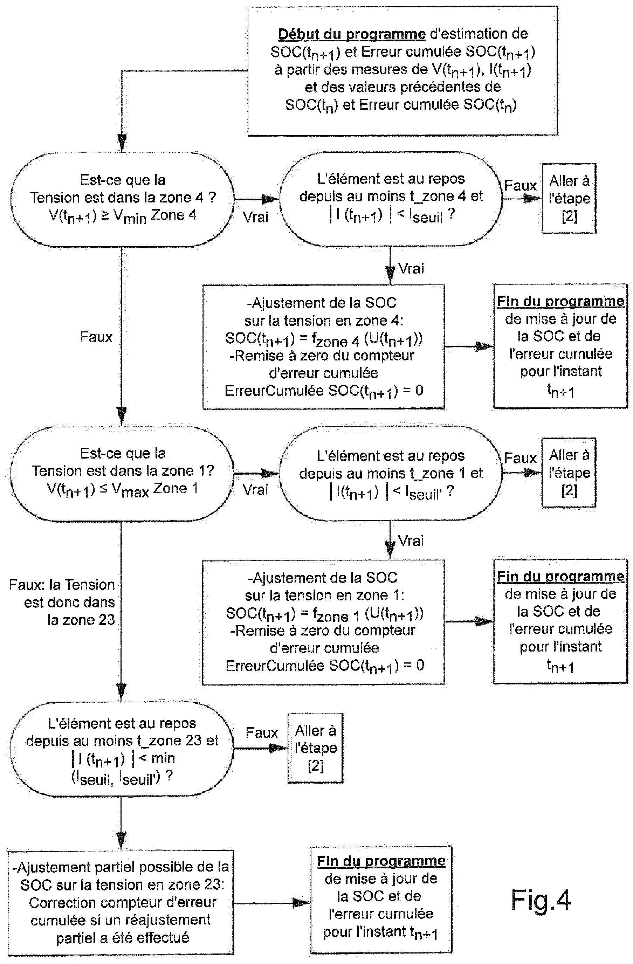

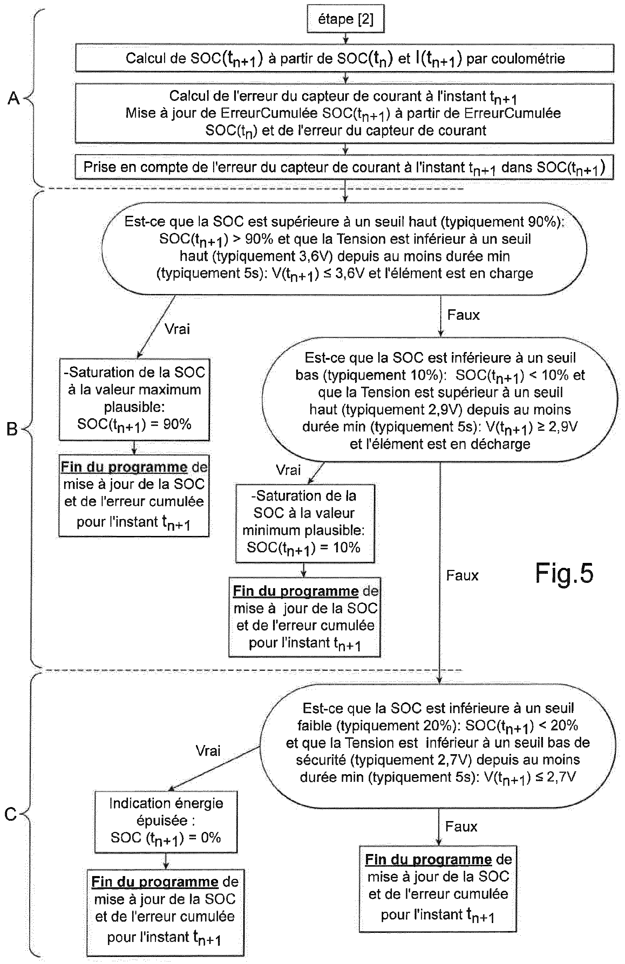

La figure 5 représente un organigramme résumant le principe d'ajustement de l'état de charge de l'élément lorsque le mode de fonctionnement de l'élément ne correspond à aucune des situations illustrées en figure 4. L'état de charge est alors déterminé par la technique de la coulométrie avec prise en compte de l'erreur de mesure sur le capteur de courant (Ensemble A). Cet organigramme schématise également l'ajustement de l'état de charge dans les deux situations suivantes :

- minoration de l'état de charge à 90% ou majoration de l'état de charge à 10 % (Ensemble B);
- détection d'un seuil bas de sécurité à 20% (Ensemble C).

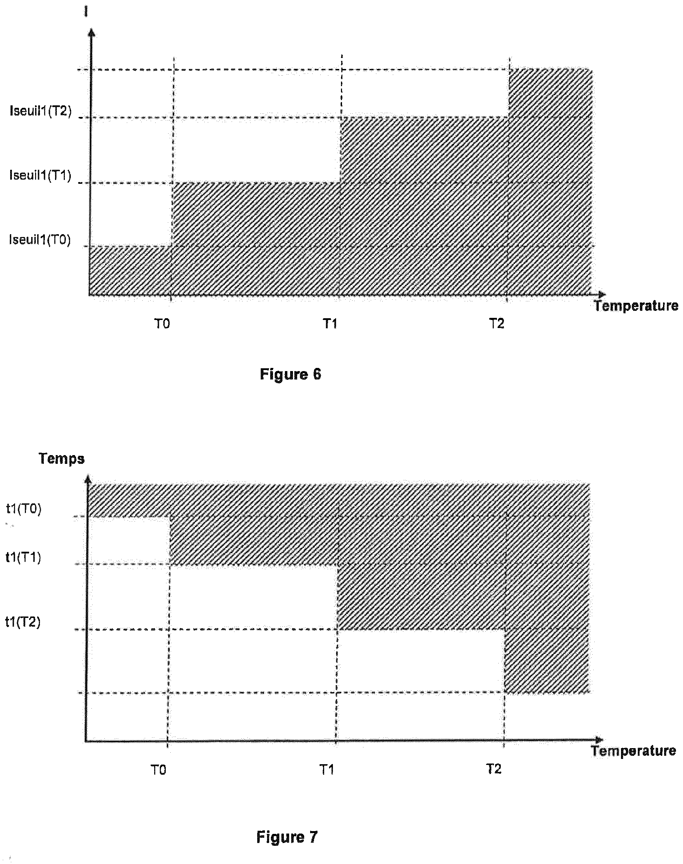

La figure 6 est un schéma de principe représentant la variation du courant seuil Iseuil (ou Iseuil') définissant la condition d'élément « au repos » en fonction de la température.

La figure 7 est un schéma de principe représentant la variation de la durée minimum avant l'autorisation de procéder à l'ajustement de la valeur d'état de charge par le principe d'étalonnage, en fonction de la température d'un élément.

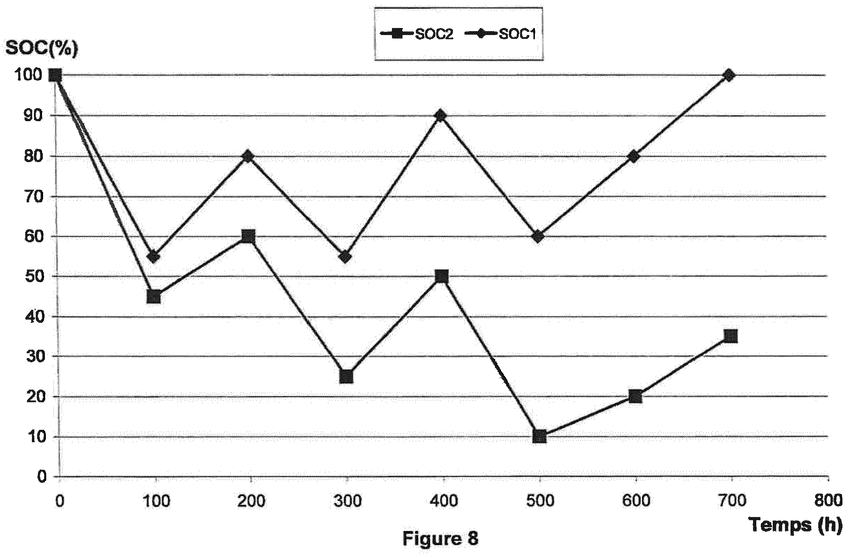

La figure 8 illustre une situation dans laquelle deux éléments électrochimiques sont soumis à une répétition de cycles de charge/décharge. L'ajustement de la valeur de leur état de charge n'est pas possible en raison de l'inexistence de période de repos. La valeur d'état de charge SOC1 d'un premier élément tend vers 100% et la valeur d'état de charge SOC2 d'un second élément tend vers 0%.

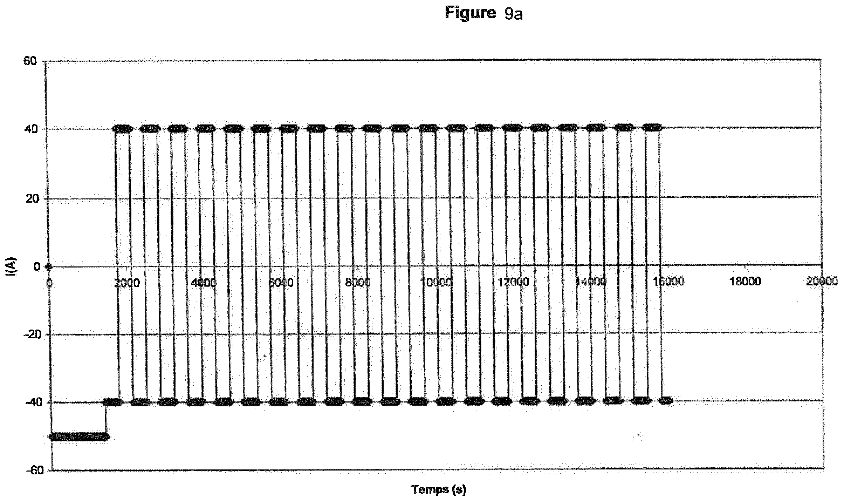

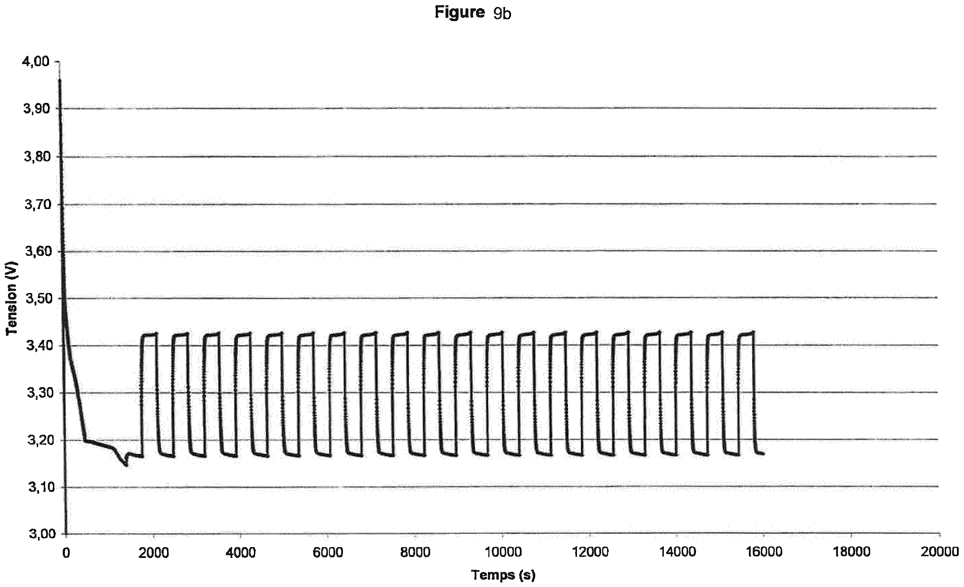

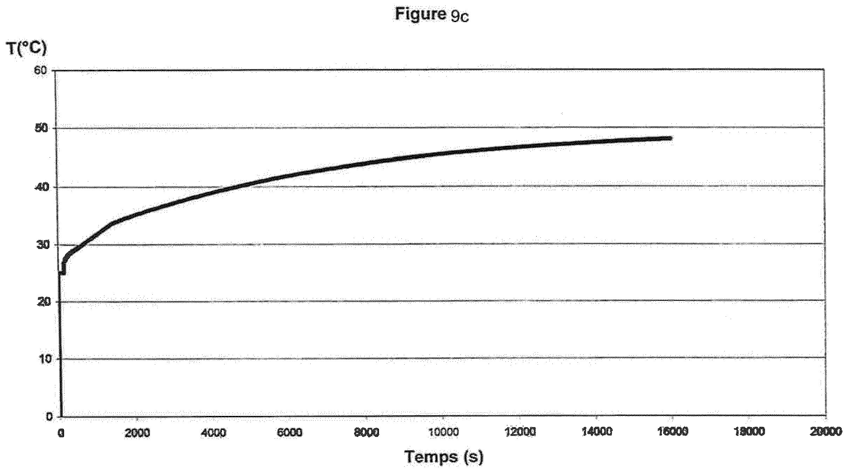

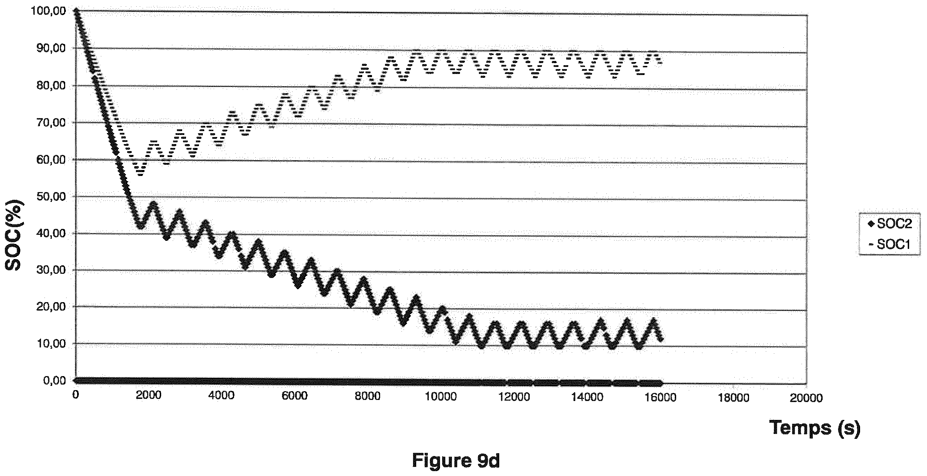

Les figures 9a, b, c et d représentent les résultats obtenus par simulation avec un capteur de courant conventionnel : erreur cumulée de gain de 10% et d'offset de 2A. La figure 9a représente la variation du courant traversant l'élément, celui-ci étant soumis à une répétition de cycles comprenant une charge à un courant de 40A suivie d'une décharge à un courant de 40A. La figure 9b représente la variation de la tension aux bornes de l'élément soumis à une répétition de cycles. La figure 9c représente l'augmentation de la température de l'élément soumis à une répétition de cycles. La figure 9d représente la limitation de SOC1 à 90% et la limitation de SOC2 à 10%.

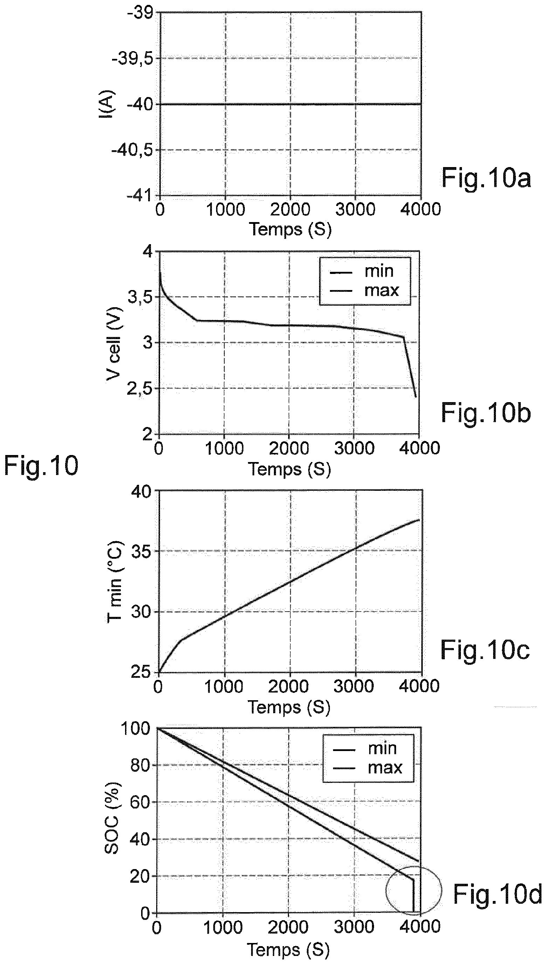

La figure 10 représente une simulation de la détection d'un seuil bas de sécurité de l'état de charge SOCminsafe. On affecte la valeur 0 % à l'état de charge lorsque celui-ci devient inférieur au seuil bas de sécurité (20 % dans l'exemple) et si la valeur de la tension en décharge $V(t_n)$ est inférieure à une valeur prédéterminée Vminsafe pendant une durée prédéterminée t8.

La figure 10a représente le courant de décharge en fonction du temps. La figure 10b représente la variation de la tension aux bornes de l'élément en fonction du temps. La figure 10c représente la variation de la température de l'élément en fonction du temps. La figure 10d représente la variation de l'état de charge en fonction du temps et la mise à zéro de l'état de charge lorsque celui-ci devient inférieur à 20%.

EXPOSE DE MODES DE REALISATION

A) Description du système d'estimation de l'état de charge:

Le système selon l'invention comprend au moins un élément (E) présentant un profil de charge (PC) dans lequel la variation de la tension en fonction de l'état de charge entre un état de charge supérieur à une valeur d'état de charge MinSOCzone2 et un état de charge inférieur à une valeur d'état de charge MaxSOCzone3 est en moyenne au moins 10 fois moins rapide que la variation de la tension pour un état de charge supérieur à MaxSOCzone3 et le profil de charge comprend en outre une zone dans laquelle la variation de la tension dudit élément E en fonction de l'état de charge pour un état de charge inférieur à MinSOCzone2 correspondant à une tension VmaxZone1 est en moyenne au moins 2 fois plus rapide que la variation de la tension pour un état de charge compris entre MinSOCZone2 et MaxSOCZone3, et

le profil de charge présente pour un état de charge compris entre MinSOCZone2 et MaxSOCZone3:

- une première sous-zone allant de MinSOCZone2 à une valeur d'état de charge MaxSOCZone2 ; la valeur MaxSOCZone2 correspondant à une valeur de tension VmaxZone2 prédéterminée;
- une seconde sous-zone allant d'une valeur d'état de charge MinSOCZone3 à MaxSOCZone3 ; la valeur d'état de charge MinSOCZone3 correspondant à une valeur de tension VminZone3 prédéterminée. Le système peut comprendre plusieurs éléments connectés entre eux dans une configuration série ou parallèle quelconque. Certains éléments peuvent être regroupés au sein d'une même enceinte pour former un module.

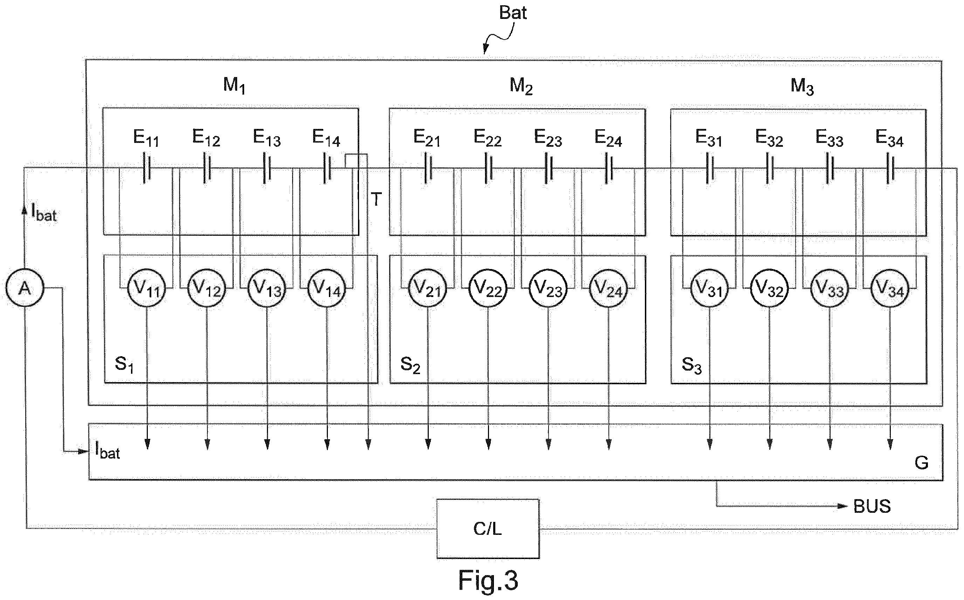

La figure 3 est un exemple de configuration dans laquelle quatre éléments électrochimiques (E11, E12, E13 et E14) sont connectés en série et disposés ensemble dans une même enceinte pour former un premier module (M1). De manière similaire, 4 éléments électrochimiques (E21, E22, E23 et E24) sont connectés en série et disposés dans une seconde enceinte pour former un second module (M2) ; 4 éléments électrochimiques (E31, E32, E33 et E34) sont connectés en série et disposés dans une troisième enceinte pour former un troisième module (M3). Les trois modules M1, M2 et M3 sont connectés en série pour former une batterie (Bat). Les trois modules constituent une branche du circuit. Bien entendu, la figure 3 n'est qu'un exemple d'application et chaque module peut comprendre un nombre d'éléments non nécessairement limité à quatre. Les éléments ne sont pas non plus nécessairement connectés en série mais peuvent aussi être connectés en parallèle. Il est également envisageable de connecter certains éléments entre eux en parallèle pour obtenir plusieurs associations d'éléments en parallèle puis de connecter ces associations d'éléments en série. De même, la batterie peut comprendre un nombre quelconque de modules, dans une configuration non nécessairement limitée à une connexion en série. Par exemple, la batterie peut comprendre p branches parallèles, chaque branche parallèle comprenant au moins un élément ou au moins un module.

Les branches de la batterie sont connectées à une source de courant (C) qui peut être un chargeur ou une application fournissant un courant de charge non régulé comme c'est le cas dans un véhicule hybride lors du freinage au cours duquel de l'énergie mécanique est convertie en énergie électrique. La source de courant fournit un courant Ibat. Si la batterie comprend p branches identiques en parallèle, alors le courant traversant chaque branche vaut Ibat/p. Dans l'exemple de la figure 3, une seule branche est représentée. Un même courant égal à Ibat traverse les modules et les éléments. Un moyen de mesure du courant (A), tel qu'une sonde à effet Hall, mesure le courant Ibat. La batterie peut se décharger à travers une application (L) connectée aux bornes de la batterie.

Chaque élément est muni d'un moyen de mesure de la tension à ses bornes. De préférence, un élément est aussi muni d'un moyen permettant de mesurer sa température de fonctionnement. Ce moyen de mesure est placé sur un point judicieusement choisi de l'élément afin d'avoir une représentation de sa température moyenne et/ou maximale et/ou minimale. Si la batterie comprend une pluralité d'éléments, chaque élément peut être muni d'un capteur de température mais cela rend plus complexe les circuits électroniques.

Dans le cas de modules regroupant différents éléments électrochimiques, les moyens de mesure de tension et de température peuvent être regroupés au sein d'un système électronique (Si), associé au module Mi. A la figure 3, les systèmes électroniques (S1, S2, S3) sont associés respectivement aux modules (M1, M2 et M3). Chaque système électronique peut également comprendre une mémoire permettant de stocker l'état du vieillissement des éléments ou du module. L'état de vieillissement d'un élément peut être caractérisé par le paramètre SOH (« State of Health ») qui indique le degré de vieillissement de l'élément entre un état neuf et un état fin de vie. L'homme du métier a à sa disposition plusieurs techniques lui permettant de calculer l'état de vieillissement d'un élément ou d'un module. L'état de vieillissement d'un élément peut par exemple être calculé soit à partir du rapport de l'impédance de l'élément à un instant donné sur l'impédance de l'élément à l'état neuf à la même température, soit à partir de l'estimation de la perte de capacité par comparaison avec la capacité de l'élément à l'état neuf.

Le système permet de déterminer individuellement l'état de charge de chaque élément électrochimique. Il comprend un système électronique de gestion G comprenant un calculateur qui :

- collecte la mesure du courant I traversant chaque élément ;
- collecte les mesures de tension de chaque élément et éventuellement les mesures de température ;
- calcule l'état de charge SOC de chaque élément par coulométrie en prenant en compte l'erreur de mesure sur la valeur du courant;

- réalise l'estimation de l'état de charge de chaque élément selon la méthode de l'invention.

De préférence, le système possède au moins un bus de communication (BUS) par exemple (CAN « Control Area Network », Ethernet) afin de fournir des informations sur l'état de l'élément ou de la batterie à un utilisateur.

De préférence, le calculateur collecte l'état de vieillissement des éléments (ou des modules).

Le système selon l'invention est adapté à l'estimation de l'état de charge d'éléments dont la matière active positive présente un profil de charge dans lequel la variation de la tension en fonction de l'état de charge entre un état de charge supérieur à MinSOCzone2 correspondant à une tension VmaxZone1 prédéterminée et un état de charge inférieur à MaxSOCzone3 correspondant à une tension VminZone4 prédéterminée est en moyenne au moins 10 fois moins rapide, de préférence au moins 20 fois moins rapide que la variation de la tension pour un état de charge supérieur à MaxSOCzone3.

De préférence, cette matière active positive comprend un phosphate de métal lithié de type $Li_xM_yP_zO_{4-t}$ dans lequel M est choisi dans le groupe comprenant Fe, Co, Ni, Mn et Al, x allant de 0,9 à 1,1, y allant de 0,9 à 1,1, z allant de 0,9 à 1,1 et t allant de 0 à 0,4, où de préférence M est Fe ou un mélange de Fe et Mn. On symbolisera ce matériau par le $LiMPO_4$.

La matière active peut également être un mélange comprenant $LiMPO_4$ et un composé de type $LiM^1O_2$ où $M^1$ représente au moins un élément de transition choisi généralement parmi Co, Ni, Fe, Mn et Al. De préférence, ce mélange comprend :

- au moins 50% en poids de $LiMPO_4$ ;
- moins de 50% en poids de l'oxyde lithié de formule $LiM^1O_2$.

En particulier, le mélange peut être tel que celui décrit dans la demande EP-A-2 269 954, c'est-à-dire comprendre :

a) un oxyde lithié de métaux de transition contenant au moins nickel, cobalt et aluminium ;
b) un phosphate lithié d'au moins un métal de transition, dont la surface est recouverte au moins partiellement d'une couche de carbone,

- la proportion massique de l'oxyde lithié de métaux de transition contenant au moins nickel, cobalt et aluminium, étant inférieure ou égale à 10% du poids de la composition.
- la proportion massique du phosphate lithié d'au moins un métal de transition étant supérieure ou égale à 90% du poids de la composition.

L'électrode négative peut comprendre un matériau carboné apte à insérer du lithium dans sa structure, par exemple à base de graphite, ou un composé de type $Li_4Ti_5O_{12}$.

B) Description de la méthode d'estimation de l'état de charge :

Le principe d'ajustement de l'état de charge d'un élément « à profil plat » dépend en particulier de la zone dans laquelle se situe sa tension. Comme expliqué ci-avant, le profil de charge comprend trois zones de tension:

Zone 4 : zone dans laquelle la tension est supérieure ou égale à VminZone4 correspondant à un état de charge supérieur ou égal à environ 90% ;
Zone 1 : une zone dans laquelle la tension est inférieure ou égale à VmaxZone1 correspondant à un état de charge inférieur ou égal à environ 30% ;
Zone 23 : une zone dans laquelle la tension est supérieure à VmaxZone1 et inférieure à VminZone 4 et qui correspond à un état de charge compris entre environ 30 et 90%. La zone 23 peut elle-même se subdiviser en deux sous-zones séparées entre elles par une partie dans laquelle la tension augmente de manière sensiblement plus importante avec l'état de charge que dans les deux sous-zones.

Le principe de l'ajustement de l'état de charge est résumé par les organigrammes des figures 4 et 5. Toutes les étapes possibles pour contrôler l'ensemble des paramètres ont été représentées. Néanmoins, il est possible que la méthode n'effectue qu'une partie des étapes. En effet, la méthode effectue au moins le contrôle de l'état de charge lorsque la tension de l'élément est dans la zone 4. De préférence, elle effectue le contrôle de l'état de charge lorsque la tension de l'élément est dans la zone 1 ou dans la zone 23.

I) Ajustement de l'état de charge de l'élément lorsque sa tension est dans la zone 4 ou la zone 1:

I-a) si d'une part l'élément E à l'instant $t_n$ est « au repos » c'est-à-dire qu'il est utilisé en charge ou en décharge à un courant inférieur en valeur absolue à une valeur seuil prédéterminée, et d'autre part que sa tension est stable au cours du temps, l'état de charge de l'élément est ajusté en lui affectant une valeur $SOCV(t_n)$ obtenue par étalonnage de la tension dudit élément en fonction de son état de charge. Cet étalonnage est réalisé préalablement en laboratoire sur un élément pris isolément et consiste à faire correspondre pour une tension donnée V aux bornes de l'élément E, un état de charge donné SOC. Cet étalonnage est réalisé de préférence en déterminant la tension à vide de l'élément en fonction de son état de charge.

Une condition d'élément « au repos » définie pour un courant nul est prise dans l'invention dans un sens élargi. En effet, un élément est la plupart du temps connecté à un réseau électrique et de ce fait, une fois connecté au réseau, le courant le traversant n'est jamais nul. On peut alors définir une valeur seuil de courant en deçà de laquelle l'élément est dit « au repos ». Dans ce qui suit, on désignera par le terme d'élément « au repos », un élément traversé par un courant d'intensité inférieure en valeur absolue à Iseuil lorsque sa tension est dans la zone 4 ou traversé par un courant d'intensité inférieure en valeur absolue à Iseuil' lorsque sa tension est dans la zone 1 ou traversé par un courant d'intensité inférieure en valeur absolue à min(Iseuil, Iseuil') lorsque sa tension est dans la zone 23.

Iseuil et Iseuil' peuvent être par exemple définis comme le rapport entre la précision du capteur de tension utilisé pour mesurer la tension aux bornes de l'élément et la résistance interne r de l'élément. Si par exemple, la précision de la mesure de tension est de 10mV et que la résistance interne de l'élément est de 2mOhm alors on obtiendra une valeur pour Iseuil ou Iseuil' de 5A.

Iseuil et Iseuil' peuvent également être définis comme la différence de tension à vide pour une variation d'état de charge prédéterminée, par exemple entre 2 et 10%, divisée par la résistance interne de l'élément. Si par exemple en zone 4, on considère une variation de tension à vide de 300mV pour 5% de variation d'état de charge (entre 90% et 95% de SOC) et que la résistance interne de l'élément est mesurée à 2mOhm alors on peut définir Iseuil= 300/2 =150A. Pour la zone 1 (moins pentue), si on considère une variation de tension à vide de 50mV pour 5% de variation d'état de charge (variation de tension moyenne entre 0% et 30% de SOC) et que la résistance interne de l'élément est mesurée à 2mOhm alors on peut définir Iseuil'= 50/2 =25A.

Iseuil et Iseuil' peuvent être égaux. La valeur de Iseuil (ou de Iseuil') peut être modulée en fonction de la température d'un élément. En effet, la résistance interne d'un élément diminue avec l'augmentation de la température. Par conséquent, la valeur de courant seuil Iseuil (ou de Iseuil') peut augmenter quand la température augmente, ce qui augmente la zone de condition d'élément au repos au sens élargi. La figure 6 représente la variation du seuil de courant définissant la condition d'élément « au repos » en fonction de la température. La zone hachurée matérialise le domaine de courant seuil Iseuil (ou Iseuil') utilisable. La zone hachurée s'étend au fur et à mesure que la température de l'élément augmente.

On ne réalise l'ajustement de l'état de charge par étalonnage de la tension que si la durée nécessaire à la stabilisation de la tension a été atteinte. La durée nécessaire à la stabilisation de la tension est spécifique à chaque zone de tension. La durée nécessaire à la stabilisation de la tension lorsque l'élément est « au repos » est désigné par t_zone4 lorsque la tension est dans la zone 4 et par t_zone1 lorsque la tension est dans la zone 1. Pour la zone 4, le temps d'attente t_zone4 varie typiquement entre 1 et 30s. Pour la zone 1, le temps d'attente t_zone1 varie typiquement entre 10 à 600s. La Figure 7 représente la variation en fonction de la température de la durée minimale avant de procéder à l'ajustement de la valeur de l'état de charge. La zone hachurée matérialise la plage de temps d'attente suffisante avant de procéder à l'ajustement. La durée suffisante diminue quand la température augmente. On pourra découper la plage de température du fonctionnement de l'élément en plusieurs domaines pour lesquels on définira une durée minimum avant d'effectuer l'ajustement sur la valeur d'état de charge.

L'ajustement de l'état de charge par étalonnage s'accompagne d'une mise à zéro d'un paramètre correspondant à l'erreur cumulée sur la détermination de l'état de charge par coulométrie.

Les étapes d'ajustement de l'état de charge par étalonnage lorsque l'élément est au repos sont schématisées à la figure 4.

Il convient de noter que lorsque l'élément est traversé par un courant d'intensité inférieure à Iseuil ou Iseuil', on peut effectuer une correction sur la valeur de VminZone4 et VmaxZone1 pour tenir compte de la résistance interne de l'élément en remplaçant d'une part :

VminZone4 par la valeur VminZone4souscourant= VminZone4+r×Iseuil ; et d'autre part :

$$\text{VmaxZone1 par la valeur VmaxZone1souscourant= VmaxZone1} + r \times \text{Iseuil' ;}$$

où :

r est la résistance interne de l'élément ;

Iseuil et Iseuil' sont définis tel que précédemment et sont positifs pour une charge et négatifs pour une décharge.

La résistance interne de l'élément varie en fonction de la température et est aisément accessible pour l'homme du métier. Elle peut en effet être mesurée en provoquant par exemple une décharge de l'élément à un courant I et en mesurant la chute de tension $\Delta U$ à ses bornes. La résistance interne est obtenue en appliquant la relation $r = \Delta U / I$. La résistance interne est quasiment constante pour un état de charge supérieur à 90% (zone 4). Pour les états de charge inférieurs à 30% (zone 1), on détermine une valeur moyenne de résistance interne dans la zone d'état de charge considérée.

On peut résumer ainsi les différentes situations d'ajustement de l'état de charge $SOCV(t_n)$ à l'instant $t_n$ à partir de la relation d'étalonnage de la tension en fonction de l'état de charge :

- si la tension V de l'élément E à l'instant $t_n$ est supérieure à VminZone4 et que l'élément est au repos pendant un temps d'attente supérieur à t_zone4, on procède à l'ajustement de l'état de charge à partir de données issues d'un étalonnage de l'élément. On attribue une valeur nulle à un paramètre correspondant à l'erreur cumulée sur l'état de charge obtenu par coulométrie ErreurcumuléeSOCC($t_n$).
- si la tension V de l'élément E à l'instant $t_n$ est inférieure à VmaxZone1 et que l'élément est au repos pendant un temps d'attente supérieur à t_zone1, on procède à l'ajustement de l'état de charge à partir de données issues d'un étalonnage de l'élément. On attribue une valeur nulle à un paramètre correspondant à l'erreur cumulée sur l'état de charge obtenu par coulométrie ErreurcumuléeSOCC($t_n$).

I-b) lorsque les conditions requises au point I-a) ne sont pas remplies, c'est-à-dire si :

- l'élément est au repos, c'est-à-dire que le courant est inférieur en valeur absolue à Iseuil (ou Iseuil'), mais pendant un temps insuffisant, i.e. inférieur à t_zone4 (ou à t_zone1), ou
- il est traversé par un courant supérieur en valeur absolue à Iseuil (ou Iseuil'),

alors on procède au calcul de l'état de charge de l'élément par coulométrie en tenant compte de l'incertitude de mesure sur la valeur du courant selon le principe expliqué ci-après :

Un capteur de courant est utilisé pour mesurer le courant I traversant l'élément. L'état de charge initial $SOC(t_0)$ de l'élément E est connu. Il peut être par exemple fixé par un utilisateur en chargeant préalablement l'élément jusqu'à ce que celui-ci atteigne une tension prédéterminée correspondant à un état de charge prédéterminé. On peut par exemple charger l'élément jusqu'à ce que sa tension atteigne 4V, laquelle valeur de tension correspond à un état de charge de 100%. Connaissant l'état de charge initial de l'élément $SOC(t_0)$ et en appliquant la technique de la coulométrie, on peut connaître à l'instant $t_n$ l'état de charge de l'élément. La quantité de courant Q traversant l'élément pendant un intervalle de temps $\Delta t$ (exprimée en h) est $Q = I \times \Delta t$ exprimée en Ah. L'état de charge est calculé à l'instant $t_n$ en intégrant la valeur du courant ayant traversé l'élément entre l'instant initial $t_0$ et l'instant $t_n$ et en rapportant la quantité d'électricité obtenue par intégration à la capacité nominale de l'élément soit :

$$SOC(t_n) = SOC(t_0) + 100 \times (\int_{0}^{n} I \times dt)/(3600 \times C) \qquad (I)$$

où :

C est la capacité de l'élément E exprimée en Ampère heure. De manière préférée, on corrige la valeur de C en tenant compte de l'état de vieillissement (SOH) de l'élément et de la variation de sa capacité selon la température à partir de données obtenus lors de tests en laboratoire. L'état de vieillissement SOH peut être déterminé par un algorithme d'estimation de l'état de vieillissement connu de la technique.

I est le courant ayant traversé l'élément (exprimé en A) entre les instants $t_0$ et $t_n$ avec I>0 en charge et I<0 en décharge ;
$SOC(t_0)$ est l'état de charge de l'élément à l'instant initial $t_0$ exprimée en % ;
$SOC(t_n)$ est l'état de charge de l'élément à l'instant $t_n$ exprimée en %.

La variation de l'état de charge pendant un intervalle de temps $\Delta t$ peut également s'écrire :

$$\Delta SOC = 100 \times \frac{I \times \Delta t}{3600 \times C} \text{ (exprimée en \%)} \quad \text{(II)}$$

où $\Delta t$ représente le temps écoulé entre deux mises à jour de l'état de charge exprimé en secondes.

On désignera dans ce qui suit par $SOCC(t_n)$ l'état de charge déterminé par coulométrie à l'aide de la relation (I) par opposition à $SOCV(t_n)$ qui est l'état de charge déterminé par étalonnage de l'état de charge en fonction de la tension.

L'état de charge calculé est corrigé pour prendre en compte l'erreur due au capteur de courant et pour déterminer un état de charge corrigé. On estime l'erreur sur l'état de charge due au capteur de courant. L'erreur sur l'état de charge est prise toujours positive et calculée selon:

$$\Delta ErreurSOC = 100 \times \frac{\left[ ErreurIOffsetSOC + \frac{\left( ErreurIGain \times Abs(I) \right)}{100} \right] \times \Delta t}{3600 \times C}$$

$$\text{(exprimé en \%) (III)}$$

avec:

ErreurIOffsetSOC : erreur d'offset du capteur de courant exprimée en Ampère. L'erreur d'offset est une constante pouvant être positive ou nulle.
ErreurIGain : erreur de gain du capteur de courant exprimée en pourcentage de la valeur mesurée, par exemple comprise entre 2 et 5% de la valeur mesurée.
Abs(I) : valeur absolue du courant traversant l'élément exprimée en Ampère.
$\Delta t$ : temps écoulé entre deux mises à jour de l'état de charge, exprimé en secondes.

L'erreur de gain du capteur ainsi que l'erreur d'offset du capteur sont des données fournies par le fabricant. Typiquement, l'erreur de gain du capteur est comprise entre 0,1% et 5% et l'offset du capteur est compris entre 0,1% Imax et 5% Imax, Imax étant le courant maximum mesurable par le capteur. L'erreur de gain sur le courant pour une mesure ponctuelle peut être d'environ 0,5%. Cette erreur se cumule au cours du temps à chaque fois que le capteur de courant effectue une mesure. L'erreur du capteur de courant est ajoutée à chaque pas dans le calcul de l'état de charge. Ainsi, si l'erreur du capteur de courant représente 0,5% pour une mise à jour de l'état de charge, alors après 200 mises à jour de l'état de charge, cette erreur représentera 10%, ce qui est significatif.

On corrige la valeur d'état de charge $SOCC(t_n)$ de l'élément E à l'instant $t_n$ en prenant en compte l'incertitude sur la mesure du courant due au capteur de courant. Soit t1, le premier instant au cours duquel on effectue on effectue la détermination de l'état de charge de l'élément par coulométrie avec correction de l'erreur. La valeur de l'état de charge $SOC(t_1)$ de l'élément à l'instant $t_1$ est encadrée par les valeurs $SOCmax(t_1)$ et $SOCmin(t_1)$ où :

$$SOCCmax(t_1) = SOCC(t_1) + \Delta ErreurSOC(t_1) \quad \text{(IV)}$$

$$SOCCmin(t_1) = SOCC(t_1) - \Delta ErreurSOC(t_1) \quad \text{(V)}$$

A l'instant $t_{n+1}$, on affecte à $SOCCmax(t_{n+1})$ la valeur $SOCCmax(t_n) + \Delta ErreurSOC(t_{n+1})$ et on affecte à $SOCCmin(t_{n+1})$ la valeur $SOCCmax(t_n) - \Delta ErreurSOC(t_{n+1})$. $SOCCmax(t_{n+1})$ et $SOCmin(t_{n+1})$ sont réévalués ainsi tant que les conditions requises pour la détermination de l'état de charge par étalonnage en fonction de la tension ne sont pas remplies.

Si l'état de charge de l'élément s'approche de la valeur 0% ou 100%, le principe d'ajustement est tel qu'expliqué au paragraphe III.

On calcule à l'instant $t_{n+1}$ l'erreur cumulée sur l'état de charge résultant de l'incertitude de mesure du capteur de courant depuis l'ajustement de l'état de charge au temps précédent $t_n$ sur la mesure de tension selon le principe suivant :

$$\text{ErreurcumuléeSOC}(t_{n+1}) = \text{ErreurcumuléeSOC}(t_n) + \Delta\text{ErreurSOC}(t_{n+1}) \text{ (exprimé en \%)}$$

$$(VI)$$

où ErreurcumuléeSOC($t_{n+1}$) représente la mise à jour de l'erreur cumulée sur l'état de charge au temps $t_{n+1}$ résultant de l'incertitude de mesure du capteur de courant. ErreurcumuléeSOC($t_n$) en représente la valeur à l'instant de mesure précédent.

Selon un mode de réalisation, si l'erreur cumulée sur l'état de charge de l'élément excède une valeur limite choisie à l'avance alors le système envoie une alerte à l'utilisateur soit sous la forme d'un signal discret ou au travers d'un message sur un bus de communication (CAN, ethernet, SPI, ...). Sinon aucune alerte n'est envoyée à l'utilisateur.

Les étapes du calcul de l'état de charge par coulométrie avec prise en compte de l'erreur du capteur de courant sont schématisées à l'ensemble A de l'organigramme de la Figure 5.

Dans le cas où plusieurs éléments électrochimiques sont regroupés en un module, on peut déterminer l'état de charge minimum et l'état de charge maximum du module. Pour ce faire, on détermine la valeur de l'état de charge de chacun des éléments, puis on détermine la valeur minimum et la valeur maximum d'état de charge parmi la pluralité des valeurs des états de charge obtenus. La valeur minimum et la valeur maximum indiquent l'état de charge minimum et l'état de charge maximum du module. Dans le cas où plusieurs modules sont regroupés en une batterie, on peut obtenir l'état de charge minimum de la batterie qui est égal à la valeur minimum de la pluralité des valeurs minimum d'état de charge des modules et l'état de charge maximum de la batterie qui est égal à la valeur maximum de la pluralité des valeurs maximum d'état de charge des modules.

II) Ajustement de l'état de charge de l'élément lorsque sa tension est dans la zone 23:

La méthode permet, en plus de gérer l'état de charge de l'élément dans la zone 4, de gérer son état de charge dans la zone 23. La zone 23 est caractérisée par un profil de charge plat. De ce fait, une relation directe entre la mesure de tension et la valeur d'état de charge ne peut être utilisée, comme dans le cas où la tension est dans la zone 1 ou la zone 4. Dans la zone 23, on exploite la valeur de la tension pour définir un encadrement de la valeur de l'état de charge comme expliqué ci-après :

II-a) si l'élément est « au repos », c'est-à-dire traversé par un courant d'intensité inférieure à min(Iseuil, Iseuil') depuis une durée supérieure à une valeur prédéterminée t_zone23 (Figure 4), on effectue un réajustement partiel de l'état de charge, c'est-à-dire que l'on considère que l'état de charge doit être compris dans une plage de valeur donnée. Pour la zone 23, la durée t_zone23 varie typiquement entre 120 et 1800s lorsque l'élément est « au repos ». L'ajustement partiel de l'état de charge est suivi d'une correction de la valeur du compteur d'erreur cumulée dans les conditions telles que décrites ci-après. Le principe de l'ajustement partiel est maintenant expliqué en référence à la Figure 2.

Si la mesure de la tension de l'élément est supérieure à VmaxZone1 et inférieure à VminZone4, alors la valeur de l'état de charge SOC est dans la zone 23. La valeur de l'état de charge doit donc être comprise entre la valeur MinSOCZone2 et la valeur MaxSOCZone3. Cinq situations sont possibles :

Situation 1 : Si SOCC($t_n$) < MinSOCZone2, alors on ajuste partiellement l'état de charge en lui affectant la valeur MinSOCZone2. Autrement dit, on attribue à l'état de charge obtenu par coulométrie SOCC($t_n$) la valeur MinSOCZone2. On retranche à l'erreur cumulée sur l'état de charge le résultat de la différence (MinSOCZone2 - SOCC($t_n$)), soit :

$$\text{ErreurcumuléeSOC}(t_n) = \text{ErreurcumuléeSOC}(t_{n-1}) - (\text{MinSOCZone2} - \text{SOCC}(t_n)).$$

Situation 2 : Si SOCC($t_n$) > MaxSOCZone3, alors on ajuste partiellement l'état de charge en lui affectant la valeur MaxSOCZone3. Autrement dit, on attribue à l'état de charge obtenu par coulométrie SOCC($t_n$) la valeur MaxSOCZone3. On retranche à l'erreur cumulée sur l'état de charge le résultat de la différence (SOCC($t_n$) - MaxSOCZone3), soit :

$$\text{ErreurcumuléeSOC}(t_n) = \text{ErreurcumuléeSOC}(t_{n-1}) - (\text{SOCC}(t_n) - \text{MaxSOCZone3}).$$

Situation 3 : si $V(t_n)$ < VmaxZone2 et si $SOCC(t_n)$ > MaxSOCZone2 alors on affecte à $SOC(t_n)$ la valeur MaxSOCZone2 et on retranche à l'erreur cumulée sur l'état de charge déterminé par coulométrie la valeur $(SOCC(t_n)$ - MaxSOCZone2) ;

Situation 4 : si $V(t_n)$ > VminZone3 et si $SOCC(t_n)$ < MinSOCZone3 alors on affecte à $SOC(t_n)$ la valeur MinSOCZone3 et on retranche à l'erreur cumulée sur l'état de charge déterminé par coulométrie la valeur (MinSOCZone3 - $SOCC(t_n)$) ;

Situation 5 : la valeur d'état de charge $SOCC(t_n)$ est cohérente avec la valeur de tension $V(t_n)$. Aucun ajustement partiel n'est effectué. On affecte à $SOC(t_n)$ la valeur $SOCC(t_n)$. On détermine l'erreur de mesure cumulée ErreurcumuléeSOCC$(t_n)$ sur la mesure de l'état de charge $SOCC(t_n)$ de l'élément E à l'instant $t_n$

Les exemples suivants illustrent les cinq situations décrites ci-dessus.

Situation 1 :

Supposons d'une part que l'opérateur ait préalablement choisi :

- les valeurs de 3,30V et 3,40 V pour les seuils de tension VmaxZone1 et VminZone4 respectivement;
- les valeurs de 30% et 90% pour les seuils d'état de charge MinSOCZone2 et MaxSOCzone3 associées aux seuils de tension VmaxZone1 et de VminZone4;

Supposons d'autre part que les mesures de courant et de tension aient donné les résultats suivants :

- un état de charge $SOCC(t_n)$ de 15% ;
- une tension de 3,32 V.

Comme la tension de l'élément de 3,32 V est comprise entre 3,30 V (VmaxZone1) et 3,40 V (VminZone4), on en déduit que la valeur de l'état de charge doit en réalité être comprise entre les valeurs d'état de charge correspondantes, c'est-à-dire entre 30 et 90%. On affecte à l'état de charge ajusté partiellement $SOC(t_n)$ la valeur de 30%. La différence entre MinSOCZone2 et l'état de charge $SOCC(t_n)$ est de 15%. On retranche alors 15% au compteur associé d'incertitude cumulée sur la valeur d'état de charge.

Situation 2 :

Supposons d'une part que l'opérateur ait préalablement choisi pour les seuils d'état de charge MinSOCZone2, MaxSOCzone3 et les seuils de tension VmaxZone1 et VminZone4 les mêmes valeurs que celles de l'exemple illustrant la situation 1 ;
Supposons d'autre part que les mesures de courant et de tension aient donné les résultats suivants :

- un état de charge tenant compte de l'erreur de mesure du capteur $SOCC(t_n)$ de 95 % ;
- une tension de 3,34 V.

Comme la tension de l'élément de 3,34 V est comprise entre 3,30 V (VmaxZone1) et 3,40 V (VminZone4), on en déduit que la valeur de l'état de charge doit en réalité être comprise entre les valeurs d'état de charge correspondantes, c'est-à-dire 30 et 90 %. On affecte à l'état de charge ajusté partiellement $SOC(t_n)$ la valeur de 90%. La différence entre l'état de charge $SOCC(t_n)$ et MaxSOCZone3 est de 5%, on retranche alors 5% au compteur associé d'incertitude cumulée sur la valeur d'état de charge minimum.

Situation 3 :

Les seuils d'état de charge MinSOCZone2, MaxSOCZone3 et les seuils de tension VmaxZone1 et VminZone4 sont les mêmes que dans la situation 1. Les seuils d'état de charge MaxSOCZone2, MinSOCZone3 ont été choisis à 60 et 65% respectivement.
Les seuils de tension VmaxZone2 et VminZone3 ont été choisis à 3,33 et 3,36 V respectivement.

Supposons que les mesures de courant et de tension aient donné les résultats suivants :

- un état de charge tenant compte de l'erreur de mesure du capteur $SOCC(t_n)$ de 70 % ;
- une tension de 3,315 V.

Comme la tension de l'élément de 3,315 V est inférieure à 3,33 V (VmaxZone2), on en déduit que la valeur de l'état de charge doit en réalité être inférieure ou égale à MaxSOCZone2 (60%). On affecte à l'état de charge ajusté partiellement $SOC(t_n)$ la valeur de 60%. La différence entre l'état de charge $SOCC(t_n)$ et MaxSOCZone2 est de 10%, on retranche alors 10% au compteur associé d'incertitude cumulée sur la valeur d'état de charge minimum.

Situation 4 :

Les valeurs de seuils de tension et de seuil d'état de charge sont les mêmes que celles de la situation 3. Supposons que les mesures de courant et de tension aient donné les résultats suivants :

- un état de charge tenant compte de l'erreur de mesure du capteur $SOCC(t_n)$ de 50 % ;
- une tension de 3,38 V.

Comme la tension de l'élément de 3,38 V est supérieure à 3,36 V (VminZone3), on en déduit que la valeur de l'état de charge doit en réalité être supérieure ou égale à MinSOCZone3 (65%). On affecte à l'état de charge ajusté partiellement $SOC(t_n)$ la valeur de 65%. La différence entre MinSOCZone3 et l'état de charge déterminé par coulométrie $SOCC(t_n)$ est de 15%, on retranche alors 15% au compteur associé d'incertitude cumulée sur la valeur d'état de charge minimum.

Situation 5 :

Les valeurs de seuils de tension et de seuil d'état de charge sont les mêmes que celles des situations 3 et 4. Supposons que l'état de charge mesuré par coulométrie $SOCC(t_n)$ soit de 45% et la tension mesurée de 3,315 V. Il y a cohérence entre la valeur d'état de charge obtenue par coulométrie et la tension mesurée. On ne procède donc pas à l'ajustement de l'état de charge. On affecte à l'état de charge $SOC(t_n)$ la valeur de 45%.

II-b) si l'intensité du courant traversant l'élément est supérieure en valeur absolue à la valeur seuil de courant prédéterminée correspondant à un élément dit « au repos » ou que la durée t_zone23 n'a pas été atteinte, l'élément étant au repos, alors la méthode détermine l'état de charge de l'élément par coulométrie en tenant compte de l'incertitude de mesure sur le capteur de courant (Figure 5, ensemble A) tel que décrit ci-dessus au paragraphe I-b). L'estimation de l'erreur due au capteur de courant et le calcul d'un état de charge prenant en compte ladite erreur de mesure permettent d'obtenir une meilleure précision sur la valeur d'état de charge par rapport à la valeur qui serait obtenue par coulométrie classique. En effet, lorsque l'élément est utilisé en permanence dans la zone 23, une coulométrie classique ne fait que faire varier l'état de charge selon le courant. Par conséquent, au fur et à mesure de l'utilisation de l'élément, l'incertitude sur l'état de charge augmente. L'estimation de l'erreur due au capteur de courant donne une indication de l'incertitude qui se cumule sur l'état de charge.

La méthode selon l'invention permet de gérer l'ajustement de plusieurs éléments indépendamment les uns des autres. Lorsqu'une batterie comprenant plusieurs éléments est au repos et que les conditions requises pour l'ajustement à partir de la tension sont réunies, on peut avoir des éléments dont la tension est ajustée en zone 4 pendant que d'autres ont une tension ajustée en zone 1 et d'autres encore ont une tension ajustée en zone 23. En ce qui concerne les durées t_zone1, t_zone23 et t_zone4 décrites ci-avant, lorsque la batterie est au repos, l'ajustement des éléments électrochimiques dont la tension est dans la zone 4 interviendra en premier, puis les éléments en zone 1 sont ajustés, et finalement si la batterie reste suffisamment au repos, on pourra ajuster les éléments situés en zone 23.

Dans un mode de réalisation, on corrige la valeur de l'état de charge ajusté par étalonnage $SOCV(t_n)$ à partir de la variation de la capacité de l'élément en fonction de la température afin de prendre en compte la diminution de l'énergie disponible pour l'utilisateur lorsque la température diminue, en particulier pour les températures négatives. A l'inverse, la capacité électrochimique augmente pour une température de fonctionnement de l'élément supérieure à sa température nominale.

Dans un mode de réalisation, on corrige les seuils d'état de charge MinSOCZone2, MaxSOCZone2, MinSOCZone3 et MaxSOCZone3 à partir de la variation de la capacité de l'élément selon la température afin de prendre en compte la diminution de l'énergie disponible pour l'utilisateur lorsque la température diminue, en particulier pour les températures négatives.

Dans un mode de réalisation, on peut également corriger les seuils d'état de charge MinSOCZone2, MaxSOCZone2, MinSOCZone3 et MaxSOCZone3 ainsi que les seuils de tensions VminZone4, VminZone3, VmaxZone2 et VmaxZone1 en fonction de l'état de vieillissement de l'élément à partir de données obtenues en laboratoire.

La méthode choisit à tout instant le principe d'estimation de l'état de charge le plus efficace selon l'utilisation qui est faite de l'élément. L'ajustement de l'état de charge est réalisé à des intervalles de temps choisis par l'utilisateur, ces intervalles de temps n'étant pas nécessairement périodiques. Les étapes décrites ci-dessus se répètent au cours du temps. Dans la situation où l'ajustement a été réalisé par étalonnage au temps $t_n$, on réinitialise au début de l'étape d'ajustement suivante au temps $t_{n+1}$, l'état de charge initial $SOC(t_0)$ en lui affectant la valeur $SOCV(t_n)$. Le temps initial $t_0$ devient $t_n$ et on incrémente l'état de charge selon la relation $SOCC(t_n)=\Delta SOCC(t_n-t_{n-1}) + SOC(t_{n-1})$ où $\Delta SOCC(t_n-t_{n-1})$ désigne la variation d'état de charge de l'élément déterminée par coulométrie entre les instants $t_{n-1}$ et $t_n$.

Dans les situations où l'ajustement est réalisé par coulométrie avec prise en compte de l'erreur due à la mesure du courant sans utiliser de relation d'étalonnage entre la tension et l'état de charge, on incrémente seulement l'état de charge selon la relation $SOCC(t_n)=\Delta SOCC(t_n-t_{n-1}) + SOC(t_{n-1})$.

III) Ajustement de l'état de charge lorsque le temps nécessaire à la stabilisation de la tension est insuffisant :

Il peut exister des situations dans lesquelles l'élément est sous courant et il n'est pas possible d'ajuster sa valeur d'état de charge par étalonnage. Tel est le cas par exemple lorsque la tension considérée se trouve dans la zone 23 et que l'élément subit des cycles répétés de charge/décharge sans période de repos permettant une stabilisation de la tension nécessaire à une mesure fiable. Il peut s'agir par exemple d'une application de l'élément dans un véhicule hybride.

La Figure 8 illustre une situation dans laquelle l'état de charge SOC1 d'un premier élément tend vers la valeur de 100% au cours du temps et l'état de charge SOC2 d'un second élément tend vers la valeur de 0% au cours du temps. Dans cet exemple, la valeur d'état de charge SOC1 et la valeur d'état de charge SOC2 ont été corrigées pour prendre en compte les erreurs respectives sur la mesure du capteur de courant selon les relations (IV) et (V). Comme il n'est pas possible de mettre à zéro la valeur de l'erreur cumulée car les conditions pour l'ajustement par étalonnage de la tension ne sont pas réunies, il se produit une dérive de SOC1 et de SOC2 vers les valeurs limites de 0 et 100%.

Afin d'éviter que les valeurs d'état de charge n'atteignent les limites de 0 et 100%, on peut limiter l'erreur due au capteur de courant dans le calcul de l'état de charge par coulométrie selon le principe décrit ci-dessous :

a) si la valeur de l'état de charge mesurée par coulométrie est supérieure à un seuil haut d'état de charge prédéterminé SOCsup, que l'élément est en charge et que sa tension $V(t_n)$ est inférieure à un seuil de tension prédéterminée en laboratoire Vs1, alors on affecte à l'état de charge $SOC(t_n)$ la valeur du seuil haut prédéterminé. Le seuil haut d'état de charge prédéterminé SOCsup peut être fixé à 90% ou à toute autre valeur comprise entre 90 et 100%. La méthode consiste donc à minorer l'état de charge en lui affectant la valeur SOCsup. Ce seuil peut être modifié en fonction de la température de l'élément. Le seuil de tension prédéterminé en laboratoire Vs1 peut être fixé à 3,65 V pour un seuil haut d'état de charge de 90%, pendant un temps d'attente supérieur à un seuil t6, valant typiquement 5s mais pouvant varier dans la gamme allant de 1s à 60s. Ce seuil de tension peut être modifié selon la valeur mesurée du courant traversant l'élément. Ce courant peut être choisi pour être inférieur au courant nominal en charge continue préconisé par le fabricant de l'élément.

La condition sur la tension de l'élément comme étant inférieure à une valeur seuil Vs1 (par exemple 3,65 V) permet de vérifier que l'état de charge réel de l'élément est bien inférieur au seuil haut d'état de charge, par exemple 90%. Si cette condition n'est pas vérifiée, cela signifie que l'état de charge est réellement supérieur à 90%. L'élément doit être en charge, sinon la décharge entraînerait une chute ohmique et donc un décalage de la tension de l'élément vers une tension inférieure, ce qui ne permettrait pas de s'assurer que la tension de l'élément est bien inférieure à ladite valeur seuil prédéterminée.

b) si la valeur de l'état de charge mesurée par coulométrie est inférieure à un seuil bas d'état de charge prédéterminé SOCinf, que l'élément est en décharge et que sa tension $V(t_n)$ est supérieure à un seuil de tension prédéterminé en laboratoire Vs2, alors on affecte à l'état de charge $SOC(t_n)$ la valeur du seuil bas prédéterminée.

Le seuil bas d'état de charge prédéterminé SOCinf peut être fixé à 10% ou à toute autre valeur comprise entre 0 et 10%. La méthode consiste donc à majorer l'état de charge en lui affectant la valeur SOCinf. Ce seuil peut être modifié en fonction de la température de l'élément.

Le seuil de tension prédéterminé en laboratoire Vs2 peut être fixé à 3V pour un seuil bas d'état de charge de 10% pendant une durée supérieure à un seuil t7, typiquement 5s, mais pouvant varier dans la gamme allant de 1s à 60s. Ce seuil de tension peut être modifié selon la valeur mesurée du courant traversant l'élément. Ce courant peut être choisi pour être inférieur au courant nominal en décharge continue préconisé par le fabricant de l'élément.

La condition sur la tension de l'élément comme étant supérieure à une valeur seuil Vs2 (par exemple 2,9V) permet de vérifier que l'état de charge réel de l'élément est bien supérieur au seuil bas d'état de charge, par exemple 10%. Si cette condition n'est pas vérifiée, cela signifie que l'état de charge est réellement inférieur à 10%. L'élément doit être en décharge, sinon la charge entraînerait un saut ohmique et donc un décalage de la tension de l'élément vers une tension supérieure, ce qui ne permettrait pas de s'assurer que la tension à vide de l'élément est bien supérieure à ladite valeur seuil prédéterminée.

Les étapes de minoration et de majoration de l'état de charge aux valeurs de 10 et 90% sont schématisées par l'ensemble B de l'organigramme de la figure 5.

Ainsi, on peut maintenir SOC1 à 90% et SOC2 à 10% bien que la tension de l'élément soit dans la zone 23 et qu'il soit sous courant de manière ininterrompue. Cela permet à l'application électrique à laquelle l'élément est connecté de continuer à fonctionner.

Les figures 9a-d représentent les résultats obtenus par simulation avec un capteur de courant peu performant : erreur cumulée de gain de 10% et d'offset de 2A. La figure 9a représente la variation du courant traversant l'élément lorsque celui-ci est soumis à une répétition de cycles formé chacun d'une décharge à un courant de 40A suivie d'une charge à un courant de 40A. La figure 9b montre la courbe de la variation de la tension de l'élément au cours du cyclage. La figure 9c représente l'augmentation de la température due à l'échauffement de l'élément au cours de la décharge. Dans une situation de cyclage, il se produit un cumul de l'erreur sur la mesure du courant à chaque mesure de capacité et comme l'état de charge n'est jamais ajusté, le compteur associé d'incertitude cumulé ErreurcumuléeSOC n'est jamais remis à zéro. Pour limiter l'augmentation de l'écart entre l'état de charge d'un premier élément et l'état de charge d'un second élément, on limite leur état de charge aux valeurs respectives de 10 et 90%. La figure 9d montre la variation de l'état de charge des deux éléments au cours du cyclage. Cette figure montre dans un premier temps une baisse de l'état de charge correspondant à une décharge au courant de -50A suivie par une succession de pics. Chaque pic correspond à la variation de l'état de charge au cours d'un cycle de charge/décharge. La partie ascendante du pic correspond à la charge au courant de 40A et la partie descendante correspond à la décharge au courant de 40A. Lorsque l'état de charge du premier élément dépasse la valeur de 90%, on lui affecte la valeur de 90% car la tension maximum est bien inférieure à un seuil de 3,6V lors de la charge. De la même manière, lorsque l'état de charge du second élément diminue en dessous de la valeur de 10%, on lui affecte la valeur de 10 % car la tension minimum est bien supérieure à 2,9V lors de la décharge

Par mesure de sécurité, on préfère donner à l'utilisateur une indication de l'état de charge de l'élément qui est sous estimée par rapport à son état de charge réel afin de garantir l'énergie disponible à l'utilisateur. D'autre part, lorsqu'un élément est en décharge et que son état de charge approche 10%, sa tension diminue rapidement. La figure 1 montre en effet que la tension d'un élément varie de plus de 300 mV pour un état de charge compris entre 0 et 10%. Il existe donc un risque d'une chute brutale de la tension de l'élément lorsque son état de charge passe en dessous de 10%. Pour prévenir cette chute brutale de tension et éviter l'éventualité que l'utilisateur de l'élément ne dispose plus d'énergie restante sans avoir été averti au préalable, la méthode comprend la fonction suivante : si l'état de charge ajusté minimum est inférieur à un seuil bas, typiquement 20%, et que la tension minimale de l'élément est inférieure à une valeur seuil prédéterminé Vminsafe en laboratoire, typiquement 2,7V, pendant une durée supérieure à un seuil t8, typiquement 5s mais pouvant varier dans la gamme de valeur allant de 1s à 60s, alors on affecte la valeur 0% à l'état de charge minimum. Ce seuil de tension Vminsafe peut être modifié selon la valeur mesurée du courant traversant l'élément. La fonction de détection d'énergie épuisée est schématisée par la partie C de l'organigramme de la figure 5.

Les figures 10a-d représentent une simulation de la détection d'un seuil bas de sécurité de l'état de charge, suite à laquelle on affecte la valeur 0% à l'état de charge. La figure 10a montre un courant constant de -40A indiquant que l'élément est soumis à une décharge continue au même courant de -40A pendant plus d'une heure. La figure 10b montre la courbe de la variation de la tension de l'élément au cours de la décharge. On observe :

- une première zone allant de 0 à environ 600 s au cours de laquelle la tension varie proportionnellement à l'état de charge;
- une seconde zone allant d'environ 600 à environ 3800 s au cours de laquelle la tension varie peu en fonction de l'état de charge ;
- une troisième zone à partir d'environ 3800 s dans laquelle on observe une chute brutale de tension.

La figure 10c représente l'augmentation de la température due à l'échauffement de l'élément au cours de la décharge. La figure 10d représente la variation linéaire de l'état de charge en fonction du temps.

Lorsque l'état de charge de l'élément descend en dessous de 20% et que sa tension est descendue en dessous de 2,7V pendant au moins 5s, on lui affecte la valeur de 0%.

**Revendications**

1. Méthode d'estimation de l'état de charge (SOC) d'un élément électrochimique (E) présentant un profil de charge (PC) dans lequel la variation de la tension en fonction de l'état de charge entre un état de charge supérieur à une valeur d'état de charge MinSOCZone2 correspondant à une tension VmaxZone1 prédéterminée et un état de charge inférieur à une valeur d'état de charge MaxSOCZone3 correspondant à une tension VminZone4 prédéterminée est en moyenne au moins 10 fois moins rapide que la variation de la tension pour un état de charge supérieur à MaxSOCZone3, et le profil de charge comprend en outre une zone dans laquelle la variation de la tension dudit élément E en fonction de l'état de charge pour un état de charge inférieur à MinSOCzone2 correspondant à une tension VmaxZone1 est en moyenne au moins 2 fois plus rapide que la variation de la tension pour un état de charge compris entre MinSOCZone2 et MaxSOCZone3, et
le profil de charge présente pour un état de charge compris entre MinSOCZone2 et MaxSOCZone3:

   - une première sous-zone allant de MinSOCZone2 à une valeur d'état de charge MaxSOCZone2 ; la valeur MaxSOCZone2 correspondant à une valeur de tension VmaxZone2 prédéterminée;
   - une seconde sous-zone allant d'une valeur d'état de charge MinSOCZone3 à MaxSOCZone3 ; la valeur d'état de charge MinSOCZone3 correspondant à une valeur de tension VminZone3 prédéterminée;

   ladite méthode comprenant les étapes suivantes :

   a) mise à disposition de l'élément ; connexion de l'élément avec un dispositif de charge ou de décharge et mesure du courant I traversant l'élément ; mise à disposition d'une relation d'étalonnage entre l'état de charge de l'élément et sa tension ;
   b) mise à disposition de l'état de charge initial $SOC(t_0)$ à un instant initial $t_0$ de l'élément (E) ; ladite méthode étant **caractérisée par** l'étape c) suivante:
   c) mesure de la tension $V(t_n)$ de l'élément E et détermination d'un état de charge ajusté $SOC(t_n)$ de l'élément E à un instant $t_n$ supérieur à $t_0$ lorsque $V(t_n)$ est supérieure ou égale à VminZone4, dans les conditions suivantes :

   i) si l'élément E est traversé par un courant $I(t_n)$ inférieur en valeur absolue à une valeur seuil de courant prédéterminée Iseuil depuis une durée supérieure à une valeur t_zone4 prédéterminée, alors on détermine une valeur $SOCV(t_n)$ à partir de la relation d'étalonnage de la tension en fonction de l'état de charge, on affecte à $SOC(t_n)$ la valeur $SOCV(t_n)$ et on attribue une valeur nulle à un paramètre correspondant à l'erreur cumulée sur l'état de charge obtenu par coulométrie ErreurcumuléeSOCC$(t_n)$;
   ii) sinon on affecte à $SOC(t_n)$ une valeur $SOCC(t_n)$ déterminée par coulométrie et on détermine l'erreur de mesure cumulée ErreurcumuléeSOCC$(t_n)$ sur la mesure de l'état de charge $SOCC(t_n)$ de l'élément E entre l'instant $t_0$ et l'instant $t_n$, et

   l'étape c) comprend en outre la détermination d'un état de charge ajusté $SOC(t_n)$ dudit élément à un instant $t_n$ supérieur à $t_0$, lorsque la tension $V(t_n)$ dudit élément est inférieure ou égale à VmaxZone1, dans les conditions suivantes :

   i) si l'élément E est traversé par un courant $I(t_n)$ inférieur en valeur absolue à une valeur seuil de courant prédéterminée Iseuil' depuis une durée supérieure à une valeur t_zone1 prédéterminée, alors on détermine une valeur $SOCV(t_n)$ à partir de la relation d'étalonnage de la tension en fonction de l'état de charge, on affecte à $SOC(t_n)$ la valeur $SOCV(t_n)$ et on attribue une valeur nulle à un paramètre correspondant à l'erreur cumulée sur l'état de charge obtenu par coulométrie ErreurcumuléeSOCC$(t_n)$ ;
   ii) sinon on affecte à $SOC(t_n)$ la valeur $SOCC(t_n)$ déterminée par coulométrie et on détermine l'erreur de mesure cumulée ErreurcumuléeSOCC$(t_n)$ sur la mesure de l'état de charge $SOCC(t_n)$ de l'élément E entre l'instant $t_0$ et l'instant $t_n$, et

   l'étape c) comprend en outre l'affectation d'une valeur $SOC(t_n)$ audit élément E à un instant $t_n$ supérieur à $t_0$ lorsque sa tension $V(t_n)$ est supérieure à VmaxZone1 et inférieure à VminZone4, dans les conditions suivantes :

   i) si l'élément E est traversé par un courant $I(t_n)$ inférieur en valeur absolue à une valeur de courant seuil prédéterminée égale à min(Iseuil, Iseuil') depuis une durée supérieure à une valeur t_zone23 prédéterminée, l'affectation se fait selon les conditions suivantes :

   - si $SOCC(t_n) >$ MaxSOCzone3 alors on affecte à $SOC(t_n)$ la valeur MaxSOCzone3 et on retranche à l'erreur cumulée sur l'état de charge déterminé par coulométrie la valeur (SOCC($t_n$) - MaxSOCzone3) ;
- si SOCC($t_n$) < MinSOCzone2 alors on affecte à SOC($t_n$) la valeur MinSOCzone2 et on retranche à l'erreur cumulée sur l'état de charge déterminé par coulométrie la valeur (MinSOCzone2 -SOCC($t_n$)) ;
- si V($t_n$) < VmaxZone2 et si SOCC($t_n$) > MaxSOCZone2 alors on affecte à SOC($t_n$) la valeur MaxSOCZone2 et on retranche à l'erreur cumulée sur l'état de charge déterminé par coulométrie la valeur (SOCC($t_n$) - MaxSOCZone2);
- si V($t_n$) > VminZone3 et si SOCC($t_n$) < MinSOCZone3 alors on affecte à SOC($t_n$) la valeur MinSOCZone3 et on retranche à l'erreur cumulée sur l'état de charge déterminé par coulométrie la valeur (MinSOCZone3 - SOCC($t_n$)) ;

ii) sinon on affecte à SOC($t_n$) un état de charge SOCC($t_n$) déterminé par coulométrie et on détermine l'erreur de mesure cumulée ErreurcumuléeSOCC($t_n$) sur la mesure de l'état de charge SOCC($t_n$) de l'élément E à l'instant $t_n$.

**2.** Méthode selon la revendication 1, dans laquelle on estime l'état de charge de l'élément E à un instant $t_{n+1}$ supérieur à $t_n$ selon les conditions suivantes :

- si la condition c)i) est remplie au temps $t_n$, alors on réinitialise l'état de charge initial SOC($t_0$) en lui affectant la valeur SOCV($t_n$) et on effectue les étapes b) et c) avec $t_0 = t_n$ et $SOCC(t_{n+1}) = \Delta SOCC(t_{n+1} - t_n) + SOC(t_n)$ ;

- si la condition c)ii) est remplie, alors $SOCC(t_{n+1}) = \Delta SOCC(t_{n+1} - t_n) + SOC(t_n)$ ; où $\Delta SOCC(t_{n+1} - t_n)$ désigne la variation d'état de charge de l'élément E déterminée par coulométrie entre les instants $t_n$ et $t_{n+1}$.

**3.** Méthode selon l'une des revendications précédentes, dans laquelle l'erreur sur l'état de charge obtenu par coulométrie $\Delta$ErreurSOC entre les instants $t_n$ et $t_{n+1}$ vaut :

$$\Delta ErreurSOC\,(\%) = 100 \times \frac{\left[ ErreurIOffsetSOC + \frac{\left(ErreurIGain \times Abs(I)\right)}{100} \right] \times (t_{n+1} - t_n)}{3600 \times C}$$

avec:

ErreurIOffsetSOC : erreur d'offset du dispositif de mesure du courant exprimée en Ampère ;
ErreurIGain : erreur de gain du dispositif de mesure du courant exprimée en pourcentage du courant mesuré ;
Abs(I) : valeur absolue du courant I traversant l'élément exprimée en Ampère ;
C : capacité de l'élément exprimée en Ampère heure ;
$t_{n+1} - t_n$ : temps écoulé entre deux mises à jours de l'état de charge, exprimé en secondes.

**4.** Méthode selon la revendication 3, dans laquelle on calcule à l'instant $t_{n+1}$ l'erreur cumulée sur l'état de charge depuis l'ajustement de l'état de charge au temps précédent $t_n$ selon la relation suivante :

$$ErreurcumuléeSOC(t_{n+1})\,(\%) = ErreurcumuléeSOC(t_n) + \Delta ErreurSOC(t_{n+1})$$

où

ErreurcumuléeSOC($t_{n+1}$) représente la mise à jour de l'erreur cumulée sur l'état de charge au temps $t_{n+1}$ résultant de l'erreur de mesure du capteur de courant ;
ErreurcumuléeSOC($t_n$) représente la valeur de l'erreur cumulée à l'instant de mesure précédent $t_n$ ; et
ErreurcumuléeSOC($t_0$)=0.

**5.** Méthode selon l'une des revendications précédentes, dans laquelle on interrompt la charge ou la décharge de l'élément lorsque l'erreur cumulée ErreurcumuléeSOCC($t_n$) de l'élément E dépasse une valeur seuil prédéterminée et/ou on envoie un message d'alerte à un utilisateur.

6. Méthode selon l'une des revendications précédentes, dans laquelle on mesure en outre la température de l'élément E et Iseuil et Iseuil' varient de manière décroissante lorsque la température de l'élément croît.

7. Méthode selon l'une des revendications précédentes, dans laquelle on mesure en outre la température de l'élément E et t_zone4, t_zone1 et t_zone23 varient de manière décroissante lorsque la température de l'élément croît.

8. Méthode selon l'une des revendications précédentes, dans laquelle on corrige les valeurs de VminZone4 et VmaxZone1 pour tenir compte de la résistance interne r de l'élément E, laquelle correction consiste à ajouter à VminZone4 et à VmaxZone1 la quantité $r \times I(t_n)$, où $I(t_n)$ est négatif lorsque l'élément est en décharge et positif lorsque l'élément est en charge.

9. Système d'estimation de l'état de charge d'au moins un élément électrochimique (E), lequel élément présente un profil de charge (PC) dans lequel la variation de la tension en fonction de l'état de charge entre un état de charge supérieur à une valeur d'état de charge MinSOCzone2 correspondant à une tension Vmaxzone1 prédéterminée et un état de charge inférieur à une valeur d'état de charge MaxSOCzone3 correspondant à une tension VminZone4 prédéterminée est en moyenne au moins 10 fois moins rapide que la variation de la tension pour un état de charge supérieur à MaxSOCzone3, et
le profil de charge comprend en outre une zone dans laquelle la variation de la tension dudit élément E en fonction de l'état de charge pour un état de charge inférieur à MinSOCzone2 correspondant à une tension VmaxZone1 est en moyenne au moins 2 fois plus rapide que la variation de la tension pour un état de charge compris entre MinSOCZone2 et MaxSOCZone3, et
le profil de charge présente pour un état de charge compris entre MinSOCZone2 et MaxSOCZone3:

   - une première sous-zone allant de MinSOCZone2 à une valeur d'état de charge MaxSOCZone2 ; la valeur MaxSOCZone2 correspondant à une valeur de tension VmaxZone2 prédéterminée;
   - une seconde sous-zone allant d'une valeur d'état de charge MinSOCZone3 à MaxSOCZone3 ; la valeur d'état de charge MinSOCZone3 correspondant à une valeur de tension VminZone3 prédéterminée;

   ledit système comprenant :

   a) un moyen de mesure du courant I traversant l'élément ;
   b) un moyen de mesure de la tension V de l'élément E;
   c) un système électronique de gestion G de l'élément, comprenant un calculateur **caractérisé en ce qu'**il est configuré pour :

      - calculer l'état de charge de l'élément E par coulométrie;
      - réaliser l'estimation de l'état de charge de l'élément E selon la méthode de l'une quelconque des revendications 1 à 8.

10. Système selon la revendication 9, comprenant en outre un moyen de mise en mémoire de l'état de vieillissement SOH de l'élément E.

11. Ensemble comprenant :

   - le système selon l'une des revendications 9 à 10;
   - au moins un élément (E) présentant un profil de charge (PC) dans lequel la variation de la tension en fonction de l'état de charge entre un état de charge supérieur à une valeur d'état de charge MinSOCZone2 correspondant à une tension VmaxZone1 prédéterminée et un état de charge inférieur à une valeur d'état de charge MaxSOCZone3 correspondant à une tension VminZone4 prédéterminée est en moyenne au moins 10 fois moins rapide que la variation de la tension pour un état de charge supérieur à MaxSOCZone3,

   et le profil de charge comprend en outre une zone dans laquelle la variation de la tension dudit élément E en fonction de l'état de charge pour un état de charge inférieur à MinSOCzone2 correspondant à une tension VmaxZone1 est en moyenne au moins 2 fois plus rapide que la variation de la tension pour un état de charge compris entre MinSOCZone2 et MaxSOCZone3, et
   le profil de charge présente pour un état de charge compris entre MinSOCZone2 et MaxSOCZone3:

      - une première sous-zone allant de MinSOCZone2 à une valeur d'état de charge MaxSOCZone2 ; la valeur MaxSOCZone2 correspondant à une valeur de tension VmaxZone2 prédéterminée ;
- une seconde sous-zone allant d'une valeur d'état de charge MinSOCZone3 à MaxSOCZone3 ; la valeur d'état de charge MinSOCZone3 correspondant à une valeur de tension VminZone3 prédéterminée.

**12.** Ensemble selon la revendication 11, dans lequel l'élément comprend une électrode positive contenant :

- soit un composé a) de formule $Li_xM_yP_zO_{4-t}$ dans laquelle M est choisi dans le groupe comprenant Fe, Co, Ni, Mn, Al et un mélange de ceux-ci, x allant de 0,9 à 1,1 et y de 0,9 à 1,1, z allant de 0,9 à 1,1 et t allant de 0 à 0,4, où M est de préférence Fe ou un mélange de Fe et Mn ;
- soit un mélange b) du composé a) avec un oxyde lithié de formule $LiM^1O_2$ dans laquelle $M^1$ désigne au moins un élément choisi parmi Co, Ni, Mn, Al et Fe, ou un mélange de ceux-ci.

**13.** Ensemble selon la revendication 12, dans lequel le matériau électrochimiquement actif choisi est une composition comprenant :

- au moins 50% en poids du composé a) ;
- moins de 50% en poids d'un oxyde lithié de formule $LiM^1O_2$ dans laquelle $M^1$ désigne au moins un élément choisi parmi Co, Ni, Mn, Al et Fe, ou un mélange de ceux-ci.

**14.** Ensemble selon la revendication 13, dans lequel la composition comprend :

- au moins 90% en poids du composé a) dont la surface est de préférence au moins partiellement recouverte d'une couche de carbone ;
- 10% ou moins en poids de l'oxyde lithié de formule $LiM^1O_2$.

**15.** Produit programme d'ordinateur comprenant au moins une séquence d'instructions stockées et accessibles à un processeur, où l'exécution du processeur conduit le système selon la revendication 9 à la mise en oeuvre des étapes de l'une quelconque des revendications 1 à 8.

**16.** Support d'information lisible par un ordinateur comprenant le programme d'ordinateur de la revendication 15.

**Patentansprüche**

**1.** Methode zum Abschätzen des Ladungszustands (SOC) eines elektrochemischen Elements (E) mit einem Ladungsprofil (PC), wobei die Veränderung der Spannung in Abhängigkeit vom Ladungszustand zwischen einem Ladungszustand, der höher ist als ein Wert des Ladungszustands MinSOCZone2, was einer vorgegebenen Spannung VmaxZone1 entspricht, und einem Ladungszustand, der geringer ist als ein Wert des Ladungszustands MaxSOCZone3, was einer vorgegebenen Spannung VminZone4 entspricht, durchschnittlich mindestens 10 mal langsamer ist als die Veränderung der Spannung für einen Ladungszustand, der höher ist als MaxSOCZone3, und das Ladungsprofil umfasst ferner einen Bereich, in dem die Veränderung der Spannung des Elements E in Abhängigkeit vom Ladungszustand für einen Ladungszustand, der geringer ist als MinSOCzone2, was einer Spannung VmaxZone1 entspricht, durchschnittlich mindestens doppelt so schnell wie die Veränderung der Spannung für einen Ladungszustand zwischen MinSOCZone2 und MaxSOCZone3 ist, und

das Ladungsprofil weist für einen Ladungszustand zwischen MinSOCZone2 und MaxSOCZone3 auf:

- einen ersten Teilbereich von MinSOCZone2 bis zu einem Wert des Ladungszustands MaxSOCZone2; wobei der Wert MaxSOCZone2 einem vorgegebenen Spannungswert VmaxZone2 entspricht;
- einen zweiten Teilbereich von einem Wert des Ladungszustands MinSOCZone3 bis MaxSOCZone3; wobei der Wert MaxSOCZone3 einem vorgegebenen Spannungswert VminZone3 entspricht;

wobei die Methode die folgenden Schritte umfasst:

a) Bereitstellen des Elements; Verbinden des Elements mit einer Lade- oder Entladevorrichtung und Messen des durch das Element fließenden Stroms I; Bereitstellen einer Kalibrierungsbeziehung zwischen dem Ladungszustand des Elements und seiner Spannung;
b) Bereitstellen eines Anfangsladungszustands $SOC(t_0)$ zu einem Anfangszeitpunkt $t_0$ des Elements (E); wobei die Methode durch den folgenden Schritt c) gekennzeichnet ist:

c) Messen der Spannung $V(t_n)$ des Elements E und Bestimmen eines angepassten Ladungszustands $SOC(t_n)$ des Elements E zu einem Zeitpunkt $t_n$, der oberhalb von $t_0$ liegt, wenn $V(t_n)$ größer oder gleich VminZone4 ist, unter den folgenden Bedingungen:

i) wenn das Element E von einem Strom $I(t_n)$ durchflossen wird, dessen Absolutwert geringer ist als ein vorgegebener Schwellwert des Stroms Iseuil ab einer Dauer, die oberhalb eines vorgegebenen Wertes t_zone4 liegt, dann wird ein Wert $SOCV(t_n)$ ausgehend von der Kalibrierungsbeziehung der Spannung in Abhängigkeit vom Ladungszustand bestimmt, $SOC(t_n)$ wird der Wert $SOCV(t_n)$ zugewiesen und ein Wert Null wird einem Parameter zugeordnet, der dem kumulativen Fehler über dem mittels Coulometrie erhaltenen Ladungszustand Erreurcumulée $SOCC(t_n)$ entspricht;

ii) ansonsten wird $SOC(t_n)$ ein durch Coulometrie bestimmter Wert $SOCC(t_n)$ zugewiesen und es wird der kumulierte Messfehler Erreurcumulée$SOCC(t_n)$ über der Messung des Ladungszustands $SOCC(t_n)$ des Elements E zwischen dem Zeitpunkt $t_0$ und dem Zeitpunkt $t_n$ bestimmt, und

der Schritt c) umfasst ferner das Bestimmen eines angepassten Ladungszustands $SOC(t_n)$ des Elements zu einem Zeitpunkt $t_n$, der oberhalb von $t_0$ liegt, wenn die Spannung $V(t_n)$ des Elements größer oder gleich VmaxZone1 ist, unter den folgenden Bedingungen:

i) wenn das Element E von einem Strom $I(t_n)$ durchflossen wird, dessen Absolutwert geringer ist als ein vorgegebener Schwellwert des Stroms Iseuil ab einer Dauer, die oberhalb eines vorgegebenen Wertes t_zone1 liegt, dann wird ein Wert $SOCV(t_n)$ ausgehend von der Kalibrierungsbeziehung der Spannung in Abhängigkeit vom Ladungszustand bestimmt, $SOC(t_n)$ wird der Wert $SOCV(t_n)$ zugewiesen und ein Wert Null wird einem Parameter zugeordnet, der dem kumulativen Fehler über dem mittels Coulometrie erhaltenen Ladungszustand Erreurcumulée $SOCC(t_n)$ entspricht;

ii) ansonsten wird $SOC(t_n)$ ein durch Coulometrie bestimmter Wert $SOCC(t_n)$ zugewiesen und es wird der kumulierte Messfehler Erreurcumulée$SOCC(t_n)$ über der Messung des Ladungszustands $SOCC(t_n)$ des Elements E zwischen dem Zeitpunkt $t_0$ und dem Zeitpunkt $t_n$ bestimmt, und

der Schritt c) umfasst ferner das Zuweisen eines Wertes $SOC(t_n)$ dem Element E zu einem Zeitpunkt $t_n$, der oberhalb von $t_0$ liegt, wenn dessen Spannung $V(t_n)$ größer als VmaxZone1 und geringer als VminZone4 ist, unter den folgenden Bedingungen:

i) wenn das Element E von einem Strom $I(t_n)$ durchflossen wird, dessen Absolutwert geringer ist als ein vorgegebener Schwellwert des Stroms in Höhe von min(Iseuil, Iseui') ab einer Dauer, die oberhalb eines vorgegebenen Wertes t_zone23 liegt, erfolgt das Zuweisen unter den folgenden Bedingungen:

- wenn $SOCC(t_n)$ > MaxSOCzone3, wird $SOC(t_n)$ der Wert MaxSOCzone3 zugewiesen und von dem kumulativen Fehler über dem durch Coulometrie bestimmten Ladungszustand wird der Wert abgezogen ($SOCC(t_n)$ - MaxSOCzone3);
- wenn $SOCC(t_n)$ < MinSOCzone2, wird $SOC(t_n)$ der Wert MinSOCzone2 zugewiesen und von dem kumulativen Fehler über dem durch Coulometrie bestimmten Ladungszustand wird der Wert abgezogen (MinSOCzone2 - $SOCC(t_n)$);
- wenn $V(t_n)$<VmaxZone2 und wenn $SOCC(t_n)$> MaxSOCZone2, wird $SOC(t_n)$ der Wert MaxSOCZone2 zugewiesen und von dem kumulativen Fehler über dem durch Coulometrie bestimmten Ladungszustand wird der Wert abgezogen ($SOCC(t_n)$ - MaxSOCZone2);
- wenn $V(t_n)$>VminZone3 und wenn $SOCC(t_n)$< MinSOC-Zone3, wird $SOC(t_n)$ der Wert MinSOCZone3 zugewiesen und von dem kumulativen Fehler über dem durch Coulometrie bestimmten Ladungszustand wird der Wert abgezogen (MinSOCZone3 - $SOCC(t_n)$);

ii) ansonsten wird $SOC(t_n)$ ein durch Coulometrie bestimmter Ladungszustand $SOCC(t_n)$ zugewiesen und es wird der kumulierte Messfehler Erreurcumulée$SOCC(t_n)$ über der Messung des Ladungszustands $SOCC(t_n)$ des Elements E zum Zeitpunkt $t_n$ bestimmt.

**2.** Methode nach Anspruch 1, wobei der Ladungszustand des Elements E zu einem Zeitpunkt $t_{n+1}$, der oberhalb von $t_n$ liegt, abgeschätzt wird, unter den folgenden Bedingungen:

- wenn die Bedingung c)i) zum Zeitpunkt $t_n$ erfüllt ist, wird der Anfangsladungszustand $SOC(t_0)$ zurückgesetzt, indem ihm der Wert $SOCV(t_n)$ zugewiesen wird, und es werden die Schritte b) und c) mit $t_0 = t_n$ und SOCC(c)

= ΔSOCC($t_{n+1}$-$t_n$) + SOC($t_n$) ausgeführt;

- wenn die Bedingung c)ii) erfüllt ist, gilt $SOCC(t_{n+1}) = \Delta SOCC(t_{n+1}-t_n) + SOC(t_n);$ wobei ΔSOCC($t_{n+1}$-$t_n$) die Änderung des durch Coulometrie bestimmten Ladungszustands des Elements E zwischen den Zeitpunkten $t_n$ und $t_{n+1}$ bezeichnet.

3. Methode nach einem der vorangehenden Ansprüche, wobei der Fehler über dem durch Coulometrie erhaltenen Ladungszustand ΔErreurSOC zwischen den Zeitpunkten $t_n$ und $t_{n+1}$ beträgt:

$$\Delta ErreurSOC(\%) = 100 \text{ x } \frac{[ErreurIOffsetSOC + \frac{(ErreurIGain \text{ x } Abs(I))}{100}] \times (tn+1-tn)}{3600 \times C}$$

mit:

ErreurIOffsetSOC = Offsetfehler der Strommessvorrichtung in Ampere;
ErreurIGain = Verstärkungsfehler der Strommessvorrichtung in % des gemessenen Stroms;
Abs(I) =: Absolutwert des durch das Element fließenden Stroms I in Ampere;
C = Kapazität des Elements in Amperestunden;
$t_{n+1}$-$t_n$ = Zeitdauer zwischen zwei Aktualisierungen des Ladungszustands in Sekunden.

4. Methode nach Anspruch 3, wobei zu dem Zeitpunkt $t_{n+1}$ der kumulative Fehler über dem Ladungszustand ab Anpassung des Ladungszustands an die vorherige Zeit $t_n$ nach der folgenden Gleichung berechnet wird:

$$ErreurcumuléeSOC(t_{n+1})(\%) = ErreurcumuléeSOC(t_n) + \Delta ErreurSOC(t_{n+1}),$$

wobei

ErreurcumuléeSOC($t_{n+1}$) = die Aktualisierung des kumulativen Fehlers über dem Ladungszustand zur Zeit $t_{n+1}$ darstellt, der aus dem Messfehler des Stromsensors resultiert;
ErreurcumuléeSOC($t_n$) = den Wert des kumulativen Fehlers zum Zeitpunkt der vorherigen Messung $t_n$ darstellt; und
ErreurcumuléeSOC($t_0$) 0 ist.

5. Methode nach einem der vorangehenden Ansprüche, wobei das Laden oder Entladen des Elements unterbrochen wird, wenn der kumulative Fehler ErreurcumuléeSOCC($t_n$) des Elements E einen vorgegebenen Schwellwert überschreitet und/oder eine Warnmitteilung an den Anwender geschickt wird.

6. Methode nach einem der vorangehenden Ansprüche, wobei ferner die Temperatur des Elements E gemessen wird und Iseuil sowie Iseuil' abnehmen, wenn die Temperatur des Elements zunimmt.

7. Methode nach einem der vorangehenden Ansprüche, wobei ferner die Temperatur des Elements E gemessen wird und t_zone4, t_zone1 sowie t_zone23 abnehmen, wenn die Temperatur des Elements zunimmt.

8. Methode nach einem der vorangehenden Ansprüche, wobei die Werte von VminZone4 und VmaxZone1 korrigiert werden, um den Innenwiderstand r des Elements E zu berücksichtigen, wobei die Korrektur darin besteht, zu VminZone4 und VmaxZone1 die Menge r x I($t_n$) hinzuzufügen, wobei I($t_n$) negativ ist, wenn das Element entladen wird, und positiv ist, wenn das Element geladen wird.

9. System zum Abschätzen des Ladungszustands mindestens eines elektrochemischen Elements (E), wobei das Element ein Ladungsprofil (PC) aufweist, bei dem die Veränderung der Spannung in Abhängigkeit vom Ladungszustand zwischen einem Ladungszustand, der höher ist als ein Wert des Ladungszustand MinSOCzone2, was einer vorgegebenen Spannung Vmaxzone1 entspricht, und einem Ladungszustand, der geringer ist als ein Wert des Ladungszustands MaxSOCzone3, was einer vorgegebenen Spannung VminZone4 entspricht, durchschnittlich mindestens 10 mal langsamer ist als die Veränderung der Spannung für einen Ladungszustand, der höher ist als MaxSOCzone3, und das Ladungsprofil umfasst ferner einen Bereich, in dem die Veränderung der Spannung des Elements E in Abhängigkeit vom Ladungszustand für einen Ladungszustand, der geringer ist als MinSOCzone2, was einer Spannung VmaxZone1 entspricht, durchschnittlich mindestens doppelt so schnell wie die Veränderung der Spannung für einen Ladungszustand zwischen MinSOCZone2 und MaxSOCZone3 ist, und das Ladungsprofil weist für einen Ladungszustand zwischen MinSOCZone2 und MaxSOCZone3 auf:

- einen ersten Teilbereich von MinSOCZone2 bis zu einem Wert des Ladungszustands MaxSOCZone2; wobei der Wert MaxSOCZone2 einem vorgegebenen Spannungswert VmaxZone2 entspricht;
- einen zweiten Teilbereich von einem Wert des Ladungszustands MinSOCZone3 bis MaxSOCZone3; wobei der Wert MaxSOCZone3 einem vorgegebenen Spannungswert VminZone3 entspricht;

wobei das System umfasst:

a) ein Mittel zur Messung des das Element durchfließenden Stroms I;
b) ein Mittel zur Messung der Spannung V des Elements E;
c) ein elektronisches System zur Verwaltung G des Elements, das einen Rechner umfasst, **dadurch gekennzeichnet, dass** er dazu ausgelegt ist:

- den Ladungszustand des Elements E durch Coulometrie zu berechnen;
- das Abschätzen des Ladungszustands des Elements E gemäß der Methode nach einem der Ansprüche 1 bis 8 durchzuführen.

10. System nach Anspruch 9, ferner umfassend ein Mittel zum Speichern des Alterungszustands SOH des Elements E.

11. Anordnung mit:

- einem System nach einem der Ansprüche 9 bis 10;
- mindestens einem Element (E), welches ein Ladungsprofil (PC) aufweist, bei dem die Veränderung der Spannung in Abhängigkeit vom Ladungszustand zwischen einem Ladungszustand, der höher ist als ein Wert des Ladungszustand MinSOCZone2, was einer vorgegebenen Spannung VmaxZone1 entspricht, und einem Ladungszustand, der geringer ist als ein Wert des Ladungszustands MaxSOCZone3, was einer vorgegebenen Spannung VminZone4 entspricht, durchschnittlich mindestens 10 mal langsamer ist als die Veränderung der Spannung für einen Ladungszustand, der höher ist als MaxSOCZone3,

und das Ladungsprofil umfasst ferner einen Bereich, in dem die Veränderung der Spannung des Elements E in Abhängigkeit vom Ladungszustand für einen Ladungszustand, der geringer ist als MinSOCzone2, was einer Spannung VmaxZone1 entspricht, durchschnittlich mindestens doppelt so schnell wie die Veränderung der Spannung für einen Ladungszustand zwischen MinSOCZone2 und MaxSOCZone3 ist, und das Ladungsprofil weist für einen Ladungszustand zwischen MinSOCZone2 und MaxSOCZone3 auf:

- einen ersten Teilbereich von MinSOCZone2 bis zu einem Wert des Ladungszustands MaxSOCZone2; wobei der Wert MaxSOCZone2 einem vorgegebenen Spannungswert VmaxZone2 entspricht;
- einen zweiten Teilbereich von einem Wert des Ladungszustands MinSOCZone3 bis MaxSOCZone3; wobei der Wert MaxSOCZone3 einem vorgegebenen Spannungswert VminZone3 entspricht;

12. Anordnung nach Anspruch 11, wobei das Element eine positive Elektrode umfasst, die enthält:

- entweder eine Verbindung a) der Formel $Li_xM_yP_zO_{4-t}$, wobei M ausgewählt ist aus der Gruppe bestehend aus Fe, Co, Ni, Mn, Al und einer Mischung derselben, x zwischen 0,9 und 1,1 und y zwischen 0,9 und 1,1 liegt, z zwischen 0,9 und 1,1 und t zwischen 0 und 0,4 liegt, wobei M bevorzugt Fe oder eine Mischung aus Fe und Mn ist;
- oder eine Mischung b) der Verbindung a) mit einem lithiierten Oxid der Formel $LiM^1O_2$, wobei $M^1$ wenigstens ein aus Co, Ni, Mn, Al und Fe ausgewähltes Element oder eine Mischung derselben bezeichnet.

13. Anordnung nach Anspruch 12, wobei das ausgewählte elektrochemisch aktive Material eine Zusammensetzung darstellt, umfassend:

- mindestens 50 Gew.-% der Verbindung a);
- mindestens 50 Gew.-% eines lithiierten Oxids der Formel $LiM^1O_2$, wobei $M^1$ wenigstens ein aus Co, Ni, Mn, Al und Fe ausgewähltes Element oder eine Mischung derselben bezeichnet.

**14.** Anordnung nach Anspruch 13, wobei die Zusammensetzung umfasst:

- mindestens 90 Gew.-% der Verbindung a), deren Oberfläche bevorzugt zumindest teilweise mit einer Kohlenstoffschicht überzogen ist;
- 10 Gew.-% oder weniger eines lithiierten Oxids der Formel $LiM^1O_2$.

**15.** Computerprogramm-Produkt, umfassend mindestens eine Sequenz von gespeicherten Anwendungen, die einem Prozessor zugänglich sind, wobei die Ausführung des Prozessors das System nach Anspruch 9 zur Durchführung der Schritte nach einem der Ansprüche 1 bis 8 veranlasst.

**16.** Computerlesbarer Informationsträger, umfassend das Computer-programm nach Anspruch 15.

**Claims**

**1.** A method for estimating state of charge (SOC) of an electrochemical cell (E) having a charge profile (PC) in which variation of voltage as a function of state of charge between a state of charge higher than a value *MinSOCZone2* of state of charge corresponding to a predetermined voltage *VmaxZone1* and a state of charge less than a value *MaxSOCZone3* corresponding to a predetermined voltage *VminZone4* is, on average, at least 10 times less rapid than variation in voltage for a state of charge greater than *MaxSOCZone3,* and wherein the charge profile further comprises an area in which variation of voltage of the cell E as a function of state of charge for a state of charge less than a value *MinSOCZone2* corresponding to a voltage *VmaxZone1* is on average at least twice as rapid as variation in voltage for a state of charge between values of *MinSOCZone2* and *MaxSOCZone3* and
wherein said charge profile for a state of charge between *MinSOCZone2* and *MaxSOCZone3* exhibits:

- a first sub-area ranging from *MinSOCZone2* to a value of state of charge *MaxSOCZone2; MaxSOCZone2* being a value corresponding to a predetermined voltage value *VmaxZone2*;
- a second sub-area ranging from a value of state of charge *MinSOCZone3* to a value of state of charge *MaxSOCZone3;* said value of state of charge *MinSOCZone3* corresponding to a predetermined voltage value *VminZone3*;

said method comprising the steps of:

a) providing a cell; connecting said cell to a device for charging or discharging it and measuring a current I through the cell; providing a calibration relationship between state of charge of the cell and voltage;
b) providing an initial state of charge $SOC(t_0)$ of said cell at an initial time to;

said method being **characterized by** the following step c):

c) measuring cell voltage $V(t_n)$ of said cell (E) and determining an adjusted state of charge $SOC(t_n)$ of said cell at a point in time $t_n$ later than to when $V(t_n)$ is greater than or equal to said voltage *VminZone4*, under the following conditions:

i) if a current $I(t_n)$ lower in absolute value than a predetermined current threshold value *Ithreshold* has been passing through said cell for longer than a predetermined value *t_Zone4*, then a value $SOCV(t_n)$ is determined from said calibration relationship of voltage as a function of state of charge, and said value $SOCV(t_n)$ is assigned to $SOC(t_n)$ and a zero value is assigned to a parameter corresponding to a cumulative error in state of charge obtained by coulometry $ErreurcumuléeSOCC(t_n)$;
ii) otherwise a value $SOCC(t_n)$ determined by coulometry is assigned to $SOC(t_n)$ and a cumulative measurement error $ErreurcumuléeSOCC(t_n)$ of the measurement of state of charge $SOCC(t_n)$ of said cell between time to and time $t_n$ is determined, and

wherein step c) further comprises determining an adjusted state of charge $SOC(t_n)$ of the cell at a time $t_n$ greater than $t_0$, when cell voltage $V(t_n)$ of said cell is less than or equal to said voltage *VmaxZone1,* under the following conditions:

i) if a current $I(t_n)$ lower in absolute value than a predetermined current threshold value *Ithreshold'* has been passing through said cell E for a period of time greater than a predetermined period of time *t_Zone1*, then

a value $SOCV(t_n)$ is determined from said calibration relationship of voltage as a function of state of charge, said value $SOCV(t_n)$ is assigned to $SOC(t_n)$ and a value of zero is assigned to a parameter corresponding to cumulative error in state of charge obtained by coulometry $ErreurcumuléeSOCC(t_n)$;

ii) otherwise a value $SOCC(t_n)$ determined by coulometry is assigned to $SOC(t_n)$ and a cumulative measurement error $ErreurcumuléeSOCC(t_n)$ in measurement of state of charge $SOCC(t_n)$ of the cell E between time to and time $t_n$ is determined, and

wherein, step c) further comprises assigning a value $SOC(t_n)$ to the cell E at a point in time $t_n$ greater than to when cell voltage $V(t_n)$ of said cell is greater than *VmaxZone1* and less than *VminZone4*, under the following conditions:

i) if the cell E is being traversed by a current $I(t_n)$ lower in absolute value than a predetermined threshold current equal to *min(Ithreshold, Ithreshold')* for a period of time greater than a predetermined value *t_Zone23*, value assigning is performed under the following conditions:

- If $SOCC(t_n)$ > *MaxSOCZone3* then the value *MaxSOCZone3* is assigned to $SOC(t_n)$ and the value *(SOCC(t_n) - MaxSOCZone3)* is subtracted from the cumulative error in state of charge value determined by coulometry;
- If $SOCC(t_n)$ < *MinSOCZone2* then the value *MinSOCZone2* is assigned to $SOC(t_n)$ and the value *(MinSOCZone2-SOCC(t_n))* is subtracted from the cumulative error in state of charge determined by coulometry;
- If $V(t_n)$ < *VmaxZone2* and if $SOCC(t_n)$ > *MaxSOCZone2* then the value *MaxSOCZone2* is assigned to $SOC(t_n)$ and the value *(SOCC(t_n) - MaxSOCZone2)* is subtracted from the cumulative error in state of charge determined by coulometry;
- If $V(t_n)$ > *VminZone3* and if $SOCC(t_n)$ < *MinSOCZone3* then *MinSOCZone3* is assigned to $SOC(t_n)$ and the value *(MinSOCZone3 - SOCC(t_n))* is subtracted from the cumulative error in state of charge determined by coulometry;

ii) otherwise a state of charge $SOCC(t_n)$ determined by coulometry is assigned to $SOC(t_n)$ and a cumulative measurement error $ErreurcumuléeSOCC(t_n)$ in measurement of state of charge $SOCC(t_n)$ of the cell E at time $t_n$ is determined.

2. The method according to claim 1, wherein state of charge of the cell E is estimated at a time $t_{n+1}$ greater than $t_n$ under the following conditions:

- if condition c) i) is satisfied at time $t_n$, then an initial state of charge $SOC(t_0)$ is reset by assigning the value $SOCV(t_n)$ thereto and steps b) and c) are performed with $t_0 = t_n$ and
$$SOCC(t_{n+1}) = \Delta SOCC(t_{n+1} - t_n) + SOC(t_n);$$

- if condition c) ii) is satisfied, then $SOCC(t_{n+1}) = \Delta SOCC(t_{n+1} - t_n) + SOC(t_n);$ wherein $\Delta SOCC(t_{n+1} - t_n)$ is variation of state of charge of said cell E determined by coulometry between times $t_n$ and $t_{n+1}$.

3. The method according to one of the preceding claims, wherein error in state of charge obtained by coulometry *ΔErreurSOC* between times $t_n$ and $t_{n+1}$ is:

$$\Delta ErreurSOC\,(\%) = 100 \times \frac{\left[ ErreurIOffsetSOC + \frac{\left( ErreurIGain \times Abs(I) \right)}{100} \right] \times (t_{n+1} - t_n)}{3600 \times C}$$

with:

ErreurIOffsetSOC: offset error of the current measuring device expressed in amperes;
ErreurIGain: gain error of the current measuring device as a percentage of measured current;
Abs (I): absolute value of the current I flowing through the cell expressed in amperes;
C: capacity of the cell expressed in ampere-hours;

$t_{n+1}$-$t_n$ is the elapsed time between two updates of state of charge, expressed in seconds.

4. The method according to claim 3, including calculating at time $t_{n+1}$ cumulative error in state of charge since adjustment of state of charge at a previous point in time $t_n$ using the following relationship:

$$\text{ErreurcumuléeSOC}(t_{n+1})\ (\%) = \text{ErreurcumuléeSOC}(t_n) + \Delta\text{ErreurSOC}(t_{n+1})$$

where

ErreurcumuléeSOC($t_{n+1}$) is updated cumulative error in state of charge at time $t_{n+1}$ resulting from measurement error in the current sensor;
ErreurcumuléeSOC($t_n$) is the value of cumulative error at the previous measurement time $t_n$, and
ErreurcumuléeSOC($t_0$) = 0.

5. The method according to one of the preceding claims, including interrupting charging or discharge of the cell when cumulative error *ErreurcumuléeSOCC($t_n$)* of said cell E exceeds a predetermined threshold value and/or sending a warning message to a user.

6. The method according to one of the preceding claims, including measuring a temperature of the cell E and the values of *Ithreshold* and *Ithreshold'* vary decreasingly as cell temperature increases.

7. The method according to one of the preceding claims, including measuring a temperature of the cell E and *t_Zone4, t_Zone1* and *t_Zone23* decrease as cell temperature increases.

8. The method according to one of the preceding claims, wherein the values of *VminZone4* and *VmaxZone1* are corrected to take account of internal resistance r of the cell E, said correction consisting in adding to *VminZone4* and *VmaxZone1* a quantity r $\times$ I($t_n$), where I($t_n$) is negative when the cell is in discharge and positive when the cell is being charged.

9. A system for estimating state of charge of at least one electrochemical cell (E) having a charge profile (PC) in which variation of voltage as a function of state of charge between a state of charge higher than a value *MinSOCZone2* of state of charge corresponding to a predetermined voltage *VmaxZone1* and a state of charge less than a value of state of charge *MaxSOCZone3* corresponding to a predetermined voltage *VminZone4* is, on average, at least 10 times less rapid than variation in voltage for a state of charge greater than *MaxSOCZone3,* and
the charge profile further comprises an area in which variation of voltage of the cell E as a function of state of charge for a state of charge less than a value *MinSOCZone2* corresponding to a voltage *VmaxZone1* is on average at least twice as rapid as variation in voltage for a state of charge between values of *MinSOCZone2* and *MaxSOCZone3,* and
said charge profile for a state of charge between *MinSOCZone2* and *MaxSOCZone3* exhibits:

- a first sub-area ranging from *MinSOCZone2* to a value of state of charge *MaxSOCZone2; MaxSOCZone2* being a value corresponding to a predetermined voltage value *VmaxZone2*;
- a second sub-area ranging from a value of state of charge *MinSOCZone3* to a value of state of charge *MaxSOCZone3*; said value of state of charge *MinSOCZone3* corresponding to a predetermined voltage value *VminZone3*;

said system comprising:

a) means for measuring a current I flowing through the cell E;
b) means for measuring voltage V of the cell;
c) an electronic data management system G for the cell, including a computer configured to:

- calculate state of charge of the cell E by coulometry;
- perform estimation of state of charge of the cell E according to the method of any one of claims 1 to 8.

10. The system of claim 9, further comprising means for storing a state of health, SOH, of said cell E.

**11.** An assembly comprising:

- the system according to one of claims 9 to 10;
- at least one cell (E) having a charge profile (PC) in which variation of voltage as a function of state of charge between a state of charge higher than a value of state of charge *MinSOCZone2* corresponding to a predetermined voltage *VmaxZone1* and a state of charge less than a value *MaxSOCZone3* corresponding to a predetermined voltage *VminZone4* is, on average, at least 10 times less rapid than variation in voltage for a state of charge greater than *MaxSOCZone3,*

and the charge profile further comprises an area in which variation of voltage of the cell E as a function of state of charge for a state of charge less than a value *MinSOCZone2* corresponding to a voltage *VmaxZone1* is on average at least twice as rapid as variation in voltage for a state of charge between values of *MinSOCZone2* and *MaxSOCZone3,* and
said charge profile for a state of charge between *MinSOCZone2* and *MaxSOCZone3* exhibits:

- a first sub-area ranging from *MinSOCZone2* to a value of state of charge *MaxSOCZone2; MaxSOCZone2* being a value corresponding to a predetermined voltage value *VmaxZone2*;
- a second sub-area ranging from a value of state of charge *MinSOCZone3* to a value of state of charge *MaxSOCZone3*; said value of state of charge *MinSOCZone3* corresponding to a predetermined voltage value *VminZone3.*

**12.** The assembly of claim 11, wherein the cell comprises a positive electrode containing:

- either a compound a) of formula $Li_xM_yP_zO_{4-t}$ wherein M is selected from the group consisting of Fe, Co, Ni, Mn, Al and mixtures thereof, x ranges from 0.9 to 1.1 and y from 0.9 to 1.1, z from 0.9 to 1.1 and t ranging from 0 to 0.4, where M is preferably Fe or a mixture of Fe and Mn;
- or a mixture b) of compound a) with a lithium-containing oxide of formula $LiM^1O_2$ wherein $M^1$ denotes at least one element selected from Co, Ni, Mn, Al and Fe, or a mixture thereof.

**13.** The assembly of claim 12, wherein the electrochemically active material is selected from a composition comprising:

- at least 50% by weight of compound a);
- less than 50% by weight of a lithium-containing oxide of formula $LiM^1O_2$ wherein $M^1$ denotes at least one element selected from Co, Ni, Mn, Al and Fe, or a mixture thereof

**14.** The assembly of claim 13, wherein the composition comprises:

- at least 90% by weight of compound a), a surface of which is preferably at least partially covered by a layer of carbon;
- 10% or less by weight of the lithium-containing oxide of the formula $LiM^1O_2$.

**15.** A computer program product that includes at least one sequence of stored instructions accessible to a processor, wherein processor execution leads to the system of claim 9 implementating the steps of any one of claims 1 to 8.

**16.** A computer-readable data carrier carrying the computer program of claim 15.

Figure 1

Figure 2

Fig.3

**Début du programme** d'estimation de
$SOC(t_{n+1})$ et Erreur cumulée $SOC(t_{n+1})$
à partir des mesures de $V(t_{n+1})$, $I(t_{n+1})$
et des valeurs précédentes de
$SOC(t_n)$ et Erreur cumulée $SOC(t_n)$

Est-ce que la
Tension est dans la zone 4 ?
$V(t_{n+1}) \geq V_{min}$ Zone 4

Vrai

L'élément est au repos
depuis au moins t_zone 4 et
$|I(t_{n+1})| < I_{seuil}$ ?

Faux

Aller à
l'étape
[2]

Vrai

-Ajustement de la SOC
sur la tension en zone 4:
$SOC(t_{n+1}) = f_{zone\ 4}(U(t_{n+1}))$
-Remise à zero du compteur
d'erreur cumulée
ErreurCumulée $SOC(t_{n+1}) = 0$

**Fin du programme**
de mise à jour de
la SOC et de
l'erreur cumulée
pour l'instant
$t_{n+1}$

Faux

Est-ce que la
Tension est dans la zone 1?
$V(t_{n+1}) \leq V_{max}$ Zone 1

Vrai

L'élément est au repos
depuis au moins t_zone 1 et
$|I(t_{n+1})| < I_{seuil'}$ ?

Faux

Aller à
l'étape
[2]

Vrai

-Ajustement de la SOC
sur la tension en zone 1:
$SOC(t_{n+1}) = f_{zone\ 1}(U(t_{n+1}))$
-Remise à zero du compteur
d'erreur cumulée
ErreurCumulée $SOC(t_{n+1}) = 0$

**Fin du programme**
de mise à jour de
la SOC et de
l'erreur cumulée
pour l'instant
$t_{n+1}$

Faux: la Tension
est donc dans
la zone 23

L'élément est au repos
depuis au moins t_zone 23 et
$|I(t_{n+1})| < min$
$(I_{seuil}, I_{seuil'})$ ?

Faux

Aller à
l'étape
[2]

-Ajustement partiel possible de la
SOC sur la tension en zone 23:
Correction compteur d'erreur
cumulée si un réajustement
partiel a été effectué

**Fin du programme**
de mise à jour de
la SOC et de
l'erreur cumulée
pour l'instant $t_{n+1}$

Fig.4

Fig.5

**Figure 6**

**Figure 7**

**Figure 8**

EP 2 634 591 B1

Figure 9a

Figure 9b

Figure 9c

Figure 9d

Fig.10a

Fig.10b

Fig.10

Fig.10c

Fig.10d

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2144075 A
- EP 2239826 A
- EP 2309615 A
- EP 2269954 A
- US 20100036627 A
- WO 2006058970 A
- FR 2942882
- US 20070170893 A
- WO 2010140044 A